(19) Europäisches Patentamt / European Patent Office / Office européen des brevets

(11) **EP 4 406 006 B1**

(12) **FASCICULE DE BREVET EUROPEEN**

(45) Date de publication et mention
de la délivrance du brevet:
**20.08.2025 Bulletin 2025/34**

(21) Numéro de dépôt: **22793141.7**

(22) Date de dépôt: **22.09.2022**

(51) Classification Internationale des Brevets (IPC):
*H01L 21/308* (2006.01)     *H01L 21/311* (2006.01)
*B81C 99/00* (2010.01)     *G03F 7/00* (2006.01)

(52) Classification Coopérative des Brevets (CPC):
**H01L 21/3083; B81C 99/009; G03F 7/0002;
H01L 21/31144**

(86) Numéro de dépôt international:
**PCT/EP2022/076451**

(87) Numéro de publication internationale:
**WO 2023/046870 (30.03.2023 Gazette 2023/13)**

(54) **PROCÉDÉ DE FABRICATION D'UN MOULE POUR NANO-IMPRESSION ET MOULE ASSOCIÉ**

VERFAHREN ZUR HERSTELLUNG EINER NANOIMPRINTFORM UND ENTSPRECHENDE FORM

METHOD FOR MANUFACTURING A NANOIMPRINT MOULD, AND ASSOCIATED MOULD

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **24.09.2021 FR 2110075**

(43) Date de publication de la demande:
**31.07.2024 Bulletin 2024/31**

(73) Titulaire: **Commissariat à l'Energie Atomique et
aux Energies
Alternatives
75015 Paris (FR)**

(72) Inventeurs:
• **TEYSSEDRE, Hubert**
**38054 Grenoble Cedex 09 (FR)**
• **POSSEME, Nicolas**
**38054 Grenoble Cedex 09 (FR)**
• **LANDIS, Stefan**
**38054 Grenoble Cedex 09 (FR)**

(74) Mandataire: **Hautier IP
20, rue de la Liberté
06000 Nice (FR)**

(56) Documents cités:
EP-A2- 0 731 387     US-A1- 2016 308 020
US-A1- 2018 001 582     US-A1- 2019 369 310

**Description**

DOMAINE TECHNIQUE DE L'INVENTION

La présente invention concerne le domaine de la lithographie par impression nanométrique, aussi désignée nano-impression. Elle trouve pour application particulièrement avantageuse la fabrication de moules maitres servant à réaliser des moules pour la réalisation de motifs présentant une haute résolution, c'est-à-dire des motifs dont les dimensions critiques sont de quelques centaines de nanomètres ($10^{-9}$ mètres), voire quelques dizaines de nanomètres.

ETAT DE LA TECHNIQUE

Les techniques de lithographie par impression nanométrique reposent sur l'impression avec un moule d'une résine déformable, déposée sur un substrat. Le moule comporte des motifs qui sont transférés dans la résine lors de l'impression. Ces motifs se mesurent couramment en dizaines de nanomètres. Le film de résine structuré par nano-impression pourra servir de masque de gravure pour des étapes suivantes de fabrication d'un dispositif microélectronique, optique ou micromécanique par exemple.

Les techniques standards d'impression nanométrique peuvent être différenciées notamment selon trois critères :

Réplication directe ou indirecte

Pour une réplication directe, le moule est directement mis en contact du film de résine à structurer. On a alors une polarité inversée entre le moule et la résine structurée.

Pour une réplication indirecte, les motifs d'un moule dit maître (communément désigné par le vocable anglais master) sont copiés dans un moule secondaire qui sera à son tour imprimé dans la résine à structurer. Le moule secondaire peut être utilisé une ou plusieurs fois selon les technologies. Ce procédé est devenu la référence des solutions industrielles car il limite le risque d'endommagement, voire de casse du moule maître.

Procédé thermique ou UV

Le choix d'un procédé mettant en œuvre une étape de solidification de la résine par un moyen thermique ou UV, dépend de la nature de la résine à structurer. Les procédés thermiques sont généralement utilisés pour la mise en forme des résines thermoplastiques non liquide à température ambiante, ou pour réticuler des résines thermodurcissables. Les procédés UV sont généralement utilisés pour réticuler les résines photosensibles. La combinaison de ces deux types de procédés est possible pour les résines hybrides pouvant demander une photo et une thermo-activation.

Rigidité des moules et du substrat

Les moules et/ou le substrat peuvent être rigides, c'est-à-dire être peu déformables peu sous l'action de leur propre poids pour des épaisseurs de quelques centaines de micromètres et avoir un module d'Young supérieur à 10 GPa (par exemple en étant à base de silicium ou d'aluminium).

Les moules notamment peuvent être souples, c'est-à-dire être déformable de façon macroscopique sous l'action de leur propre poids pour des épaisseurs allant jusque quelques centaines de micromètres et avoir un module d'Young inférieur à 10 GPa (par exemple en étant à base de polyéthylène téréphtalate PET, polycarbonate PC, etc.).

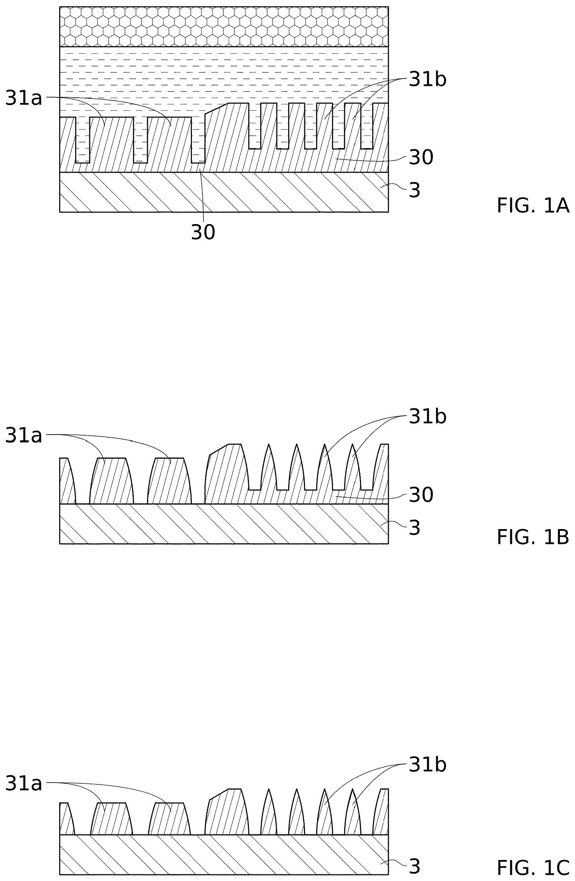

Quelle que soit la technique employée, la nano-impression implique des déplacements et/ou écoulement de résine lors du transfert de motif, afin que les espaces libres entre les motifs du moule soient remplis par la résine. En pratique l'homme du métier choisit la quantité de résine initiale de façon à laisser une épaisseur résiduelle 30 sous les motifs 31a, 31b, tel qu'illustré par exemple sur la figure 1A.

Ce remplissage par la résine implique que la quantité de résine nécessaire dépend de la densité de motifs si la hauteur de ces derniers est constante. De ce fait, si la densité des motifs varie en fonction des endroits sur un moule, alors les volumes de résine pour les remplir et obtenir une épaisseur résiduelle homogène seront différents, ou bien, à volume initial équivalent de résine, l'épaisseur résiduelle de résine ne sera pas homogène dans la couche de résine imprimée, comme illustré sous les motifs 31a et 31b en figure 1A. C'est en particulier le cas pour les technologies qui utilisent du dépôt à la tournette (généralement désigné par le terme anglais *spin-coating*) pour l'étalement de résine, suite auquel l'épaisseur de résine est sensiblement constante en tout point de la surface du substrat avant l'impression.

La variation de l'épaisseur résiduelle induit des limitations pour la gravure des motifs 31a, 31b dans le substrat 3. En effet, cette gravure comprend généralement une étape préliminaire de retrait de l'épaisseur résiduelle 30 de résine par un procédé anisotrope. Le retrait complet de cette épaisseur résiduelle 30 intervient généralement d'abord dans les motifs 31a les moins denses, comme illustré par la figure 1B, puis dans les motifs 31b les plus denses, comme illustré par la figure 1C. Cela entraine un risque de perte des dimensions critiques des motifs par rapport aux motifs du moule, et une diminution importante de la quantité de résine pouvant être ensuite consommée lors de la gravure du motif.

Pour éviter cela, des solutions consistent à adapter la hauteur des motifs sur le moule en fonction de la densité des motifs, pour obtenir une épaisseur résiduelle de résine sensiblement homogène.

Pour cela, une première solution consiste à séparer les motifs à réaliser en ensembles de motifs, chaque ensemble présentant des motifs avec une densité moyenne donnée, les ensembles entre eux présentant des densités de motifs différentes. Un moule par ensemble est alors réalisé et les étapes de copie du master et de dépôt de la résine sont effectuées successivement par ensemble de motifs, de façon à avoir une épaisseur résiduelle homogène entre les différents ensemble.

Une deuxième solution consiste à fabriquer un master présentant différentes hauteurs de motifs correspondant aux différentes densités. Sur le master à fabriquer, on sépare les motifs à réaliser en ensembles de motifs, chaque ensemble présentant des motifs avec une densité moyenne donnée, les ensembles entre eux présentant des densités de motifs différentes. Les différents ensembles de motifs du moule sont fabriqués par application d'un masque puis lithographie successivement pour chaque ensemble, de sorte que chaque ensemble présente la hauteur de motif appropriée.

Quelle que soit la solution ci-dessus, ces solutions demandent de nombreuses étapes et sont complexes à mettre en œuvre. Notamment, ces solutions présentent de fortes contraintes en termes d'alignement des différents ensembles de motifs au cours des étapes successives de fabrication. Pour l'alignement de ces ensembles, les équipements actuels permettent de façon générale une résolution latérale comprise entre 2 et 10 µm. Une résolution inférieure à 100 nm, et de préférence de l'ordre de 10 nm serait à avoir pour permettre un alignement fiable et reproductible.

US 2019/369310 A1 décrit un procédé de fabrication d'un moule pour nano-impression.

US 2016/308020 A1 décrit un moule pour nano-impression.

Il existe donc un besoin consistant à proposer une solution pour améliorer la fabrication d'un moule pour la nano-impression, permettant de contrôler l'épaisseur résiduelle de résine.

Les autres objets, caractéristiques et avantages de la présente invention apparaîtront à l'examen de la description suivante et des dessins d'accompagnement. Il est entendu que d'autres avantages peuvent être incorporés.

RESUME DE L'INVENTION

Pour atteindre cet objectif, selon un mode de réalisation on prévoit un procédé de fabrication d'un moule pour nano-impression comprenant une fourniture d'un substrat comprenant une couche présentant une face supérieure et une face inférieure opposée à la face supérieure.

Le procédé comprend en outre au moins une implantation ionique dans au moins une portion de la couche, l'implantation ionique étant configurée de façon à obtenir au sein de la couche au moins une première portion non implantée ou présentant une première implantation, et au moins une deuxième portion présentant une deuxième implantation, la première implantation et la deuxième implantation étant différentes, les première et deuxième portions s'étendant chacune depuis ladite face supérieure, l'implantation ionique définissant en outre une troisième portion non implantée, s'étendant au moins depuis la première portion, et de préférence depuis les première et deuxième portions, jusqu'à la face inférieure de la couche.

Après ou avant l'implantation, le procédé comprend la réalisation un masque dit de gravure surmontant la face supérieure et présentant une pluralité d'ouvertures.

Après l'implantation, le procédé comprend une gravure de la couche configurée de façon à présenter une vitesse de gravure différente au moins entre la deuxième portion et la troisième portion, de préférence entre les première et deuxième portions et la troisième portion, de façon à graver à travers les ouvertures du masque de gravure une pluralité de motifs de différentes hauteurs dans la couche, au moins un motif s'étendant dans la première portion et au moins un motif s'étendant dans la deuxième portion, la gravure étant configurée pour graver dans la première portion un premier ensemble de motifs et pour graver dans la deuxième portion un deuxième ensemble de motifs :

i. le premier ensemble de motifs présentant une première densité D1 de motifs et une première hauteur H1,
ii. le deuxième ensemble de motifs présentant une deuxième densité D2 de motifs, et une deuxième hauteur H2, et dans lequel D2>D1.

L'implantation ionique permet de modifier les propriétés de gravure de la deuxième portion, le cas échéant de la première portion, par l'implantation d'ions dans la couche. Ainsi, lors de la gravure des motifs dans chacune de ces portions, la vitesse de gravure différant entre les portions implantées et non implantées, éventuellement entre portions implantées de différente nature, des motifs de hauteurs différentes sont obtenues pour une même étape de gravure, par exemple pour un même temps de gravure. Il n'est dès lors plus nécessaire de réaliser successivement les motifs pour chaque hauteur de motif. Les contraintes d'alignements sont dès lors minimisées, et de préférence évitées.

Le procédé de fabrication du moule est par conséquent simplifié. Le coût de fabrication du moule est réduit. En outre, le procédé de fabrication est fiabilisé, puisque les contraintes liées à l'alignement entre différents motifs de hauteurs différentes sont relâchées.

Selon un exemple, la première implantation et la deuxième implantation diffèrent par au moins un paramètre parmi : une profondeur d'implantation, une nature des ions implantés, une dose en ions implantées. Ainsi, les première et deuxième portions diffèrent par l'un de ces paramètres, modifiant la vitesse de gravure entre ces portions.

Un autre aspect concerne un moule pour nano-impression comprenant un substrat comprenant une couche présentant une face supérieure et une face inférieure opposée à la face supérieure et plusieurs motifs s'étendant depuis la face supérieure, la couche étant destinée à pénétrer dans une couche à imprimer pour y transférer les motifs, au moins l'un des motifs présentant une hauteur différente d'un autre motif, la couche comprenant au moins une première portion non implantée ou présentant une première implantation, et au moins une deuxième portion présentant une deuxième implantation, la première implantation et la deuxième implantation étant différentes, les première et deuxième portions s'étendant chacune depuis ladite face supérieure, et une troisième portion non implantée s'étendant au moins depuis la première portion, et de préférence depuis les première et deuxième portions, jusqu'à la face inférieure de la couche, un premier ensemble de motifs s'étendant dans la première portion et un deuxième ensemble de motifs s'étendant dans la deuxième portion, avec :

    i. le premier ensemble de motifs présentant une première densité D1 de motifs et une première hauteur H1,
    ii. le deuxième ensemble de motifs présentant une deuxième densité D2 de motifs, et une deuxième hauteur H2, et dans lequel D2>D1.

Le moule présente ainsi les avantages du procédé de fabrication selon le premier aspect. Notamment, les motifs de différentes hauteurs portés par la couche sont fiabilisés par rapport aux motifs que l'on souhaite obtenir par nano-impression. Les alignements entre les motifs de différentes hauteurs sont en effet facilités grâce au procédé de fabrication. Au final, par rapport aux solutions connues, le moule proposé permet de réduire les imprécisions d'alignement et améliore la précision globale de l'impression réalisée. Le moule permet donc de simplifier la nano-impression en évitant de multiples étapes d'impression sur le substrat à imprimer, et de fiabiliser la nano-impression par rapport aux solutions existantes mettant en oeuvre un moule présentant des motifs de hauteurs différentes. En outre, le coût du moule est réduit par rapport à ces solutions.
Selon un exemple le moule est un moule dit maître, destiné à servir à la réalisation de moules secondaires.

BREVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :

    Les figures 1A à 1C représentent des étapes de transfert de motifs et de gravure pour éliminer l'épaisseur résiduelle de résine après transfert, selon une solution de l'état de la technique existant.
    Les figures 2A et 2B représentent une vue en coupe transversale du substrat comprenant un masque d'implantation présentant une première épaisseur $E_1$ et une deuxième épaisseur $E_2$ selon deux exemples de réalisation du procédé.
    Les figures 3A et 3B représentent une vue en coupe transversale du substrat respectivement illustré par les figures 2A et 2B, après une implantation ionique selon un exemple de réalisation du procédé.
    La figure 3C représente une vue en coupe transversale du substrat illustré par la figure 2B, après une implantation ionique selon un autre exemple de réalisation du procédé que celui illustré par les figures 3A et 3B.
    Les figures 4A à 4C représentent une vue en coupe transversale du substrat illustré par la figure 3A, lors des étapes de gravure des motifs selon un exemple de réalisation du procédé.
    Les figures 5A à 5C représentent une vue en coupe transversale du substrat illustré par la figure 3C, lors des étapes de gravure des motifs selon un exemple de réalisation du procédé.
    Les figures 6A et 6B représentent une vue en coupe transversale du substrat après une implantation ionique localisée, selon deux autres exemples de réalisation du procédé.
    Les figures 6C et 6D représentent une vue en coupe transversale du substrat illustré par l'une quelconque des figures 6A et 6B, lors des étapes de gravure des motifs selon un exemple de réalisation du procédé.
    Les figures 6E à 6G représentent une vue en coupe transversale d'un mode de réalisation dans lequel le moule est un moule maître permettant la réalisation d'un moule secondaire et le pressage de ce dernier pour réaliser un motif final.
    Les figures 7A et 7B représentent des diagrammes d'implantation d'ions respectivement dans la silice $SiO_2$ et dans une photorésine.
    Les figures 8A à 8C représentent une vue en coupe transversale d'un mode de réalisation dans lequel le moule est un moule direct et le pressage de ce dernier pour réaliser un motif final.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier les dimensions relatives des masques, des couches, des portions de couches et des motifs et ouvertures ne sont pas représentatives de la réalité.

DESCRIPTION DÉTAILLÉE DE L'INVENTION

Avant d'entamer une revue détaillée de modes de réalisation de l'invention, sont énoncées ci-après des caractéristiques optionnelles qui peuvent éventuellement être utilisées en association ou alternativement.

Selon l'invention, la gravure est configurée pour graver dans la première portion un premier ensemble de motifs et pour graver dans la deuxième portion un deuxième ensemble de motifs :

- le premier ensemble de motifs présentant une première densité $D_1$ de motifs et une première hauteur $H_1$,
- le deuxième ensemble de motifs présentant une deuxième densité $D_2$ de motifs, et une deuxième hauteur $H_2$, et $D_2>D_1$, et optionnellement $H_2>H_1$.

Ainsi, pour une densité inférieure de motifs, la hauteur $H_1$ est plus faible que la hauteur des motifs pour une densité de motif plus grande. L'adaptation de la hauteur en fonction de la densité des motifs permet d'améliorer encore l'homogénéité de la couche de résine résiduelle lors de la nano-impression.

Les hauteurs des motifs gravés sont mesurées depuis la face supérieure de la couche et jusqu'à un fond des motifs. Cette mesure est de préférence prise selon une direction perpendiculaire à un plan dans lequel s'étend principalement la face supérieure. De préférence cette direction est parallèle à la direction privilégiée d'implantation.

Selon un exemple, la gravure est configurée de sorte que la vitesse de gravure au moins de la deuxième portion, de préférence des première et deuxième portions, est supérieure à la vitesse de gravure de la troisième portion non-implantée. Ainsi, la troisième portion non-implantée forme une couche de freinage, voire une couche d'arrêt, de la gravure, permettant de contrôler la hauteur du motif gravé à partir des portions implantées.

Selon un exemple, préalablement à l'implantation ionique, et de préférence avant la réalisation du masque de gravure, le procédé comprend la réalisation d'un masque dit d'implantation sur au moins une portion de la face supérieure de la couche, et l'implantation ionique est au moins en partie réalisée à travers le masque d'implantation de sorte que la première portion implantée présente une première profondeur d'implantation $P_1$ et la deuxième portion implantée présente une deuxième profondeur d'implantation $P_2$, avec $P_2$ strictement supérieure à $P_1$ et $P_1$ nulle ou supérieure à 0.

Le masque d'implantation permet de créer une différence de hauteur à la surface de la couche. Lors de l'implantation ionique, la pénétration des ions dans la couche va être impactée par la présence ou non d'un masque, et l'éventuelle variation d'épaisseur du masque d'implantation au-dessus de la couche. Selon l'endroit implanté, les ions vont donc progresser jusqu'à différentes profondeurs. Le gradient de profondeur permet de moduler les vitesses de gravure des motifs selon la normale au plan d'extension principale de la face supérieure. Pour une faible profondeur d'implantation, les motifs gravés présentent par exemple une hauteur plus petite. Pour une profondeur d'implantation plus importante, les motifs gravés présentent par exemple une hauteur plus grande.

La profondeur implantée est mesurée depuis la face supérieure de la couche et selon une direction perpendiculaire à un plan dans lequel s'étend principalement la face supérieure. De préférence cette direction est parallèle à la direction privilégiée d'implantation.

Selon un exemple, le moule est dit souple, c'est-à-dire qu'il est déformable sous l'action de leur propre poids et/ou d'un effort de pressage dans une couche de résine. Typiquement pour des épaisseurs allant jusque quelques centaines de micromètres et avoir un module d'Young par exemple inférieur à 10 GPa

Selon un exemple, le masque d'implantation est configuré pour recouvrir uniquement une portion de la face supérieure de la couche.

Selon un exemple, $P_2$ est strictement supérieur à $P_1$, et $P_1$ est non nulle. Ainsi, toute la face supérieure est implantée, à des profondeurs différentes.

Selon un exemple, $P_2$ est strictement supérieur à $P_1$, et $P_1$ est nulle. Ainsi, une fraction de la face supérieure n'est pas implantée.

Selon un exemple, le masque d'implantation est configuré de sorte à présenter un gradient d'épaisseur entre au moins une première épaisseur $E_1$ et une deuxième épaisseur $E_2$, avec $E_1$ strictement supérieure à $E_2$ et $E_2$ nulle ou supérieure à 0.

De préférence $E_2$ est strictement supérieure à 0. Ainsi la couche est recouverte par le masque sur la surface de sa première portion et de sa deuxième portion. Cela améliore la qualité de l'interface entre le masque d'implantation et le substrat après l'implantation ionique. EN effet, si $E_2$ est nulle, alors la surface de la couche n'est pas protégée pendant l'implantation ionique au niveau de la surface de la deuxième portion. En fonction des conditions d'implantations, il est possible que les propriétés de la deuxième portion, non protégée, soit différentes de celles de la première portion protégée par le masque d'implantation. Par conséquent on peut avoir des comportements à la gravure différents. Il **est donc avantageux** que les première et deuxième portions soit recouvertes par le masque d'implantation d'épaisseur non-nulle, pour obtenir une surface de propriété homogène à l'issue de l'implantation.

Selon un exemple, le gradient d'épaisseur du masque entre $E_1$ et $E_2$ est sensiblement égal à la différence de profondeur entre $P_1$ et $P_2$.

Selon un exemple, la première épaisseur $E_1$ est sensiblement comprise entre 50 nm et 100 $\mu$m. Selon un exemple, la deuxième épaisseur $E^2$ est sensiblement comprise entre 0 nm et E1.

Selon un exemple, le procédé comprend un retrait du masque après l'implantation et avant l'étape de gravure.

Selon un exemple, l'implantation ionique est configurée de sorte qu'au moins la deuxième profondeur d'implantation $P_2$, et de préférence les première $P_1$ et

deuxième $P_2$ profondeurs, est/sont supérieure(s) ou égale(s) à 30 nm, de préférence strictement supérieure(s) à 30 nm. Selon un exemple, l'implantation ionique est configurée de sorte qu'au moins une, et de préférence chacune, parmi les première et deuxième profondeurs d'implantation est inférieure ou égale à 1 $\mu$m ($10^{-6}$ mètre). De préférence, l'implantation ionique est configurée de sorte qu'au moins une, et de préférence chacune, parmi les première et deuxième profondeurs d'implantation est comprise entre 30 nm et 1 $\mu$m.

L'implantation ionique peut ainsi être faite sur une profondeur sensiblement égale à la hauteur du motif qui sera obtenu par gravure. Ceci est particulièrement avantageux pour mettre en œuvre une gravure sélective de la portion implantée par rapport à la portion non-implantée. La portion non-implantée sous la portion implantée peut ainsi servir de couche d'arrêt lors de la gravure.

Selon un exemple, l'implantation ionique est faite par un implanteur.

Selon un exemple, l'implantation ionique est configurée de sorte que les première $P_1$ et deuxième $P_2$ profondeurs d'implantation sont inférieures ou égale à 30 nm, de préférence inférieure ou égale à 10 nm. L'implantation ionique peut ainsi être faite en surface de la couche. Les portions implantées peuvent servir d'amorce de freinage ou de préférence d'accélération à la gravure pour fabriquer les motifs.

Selon un exemple, l'implantation ionique est faite par un plasma.

Selon un exemple, le masque d'implantation est configuré de sorte que les première et deuxième portions sont espacées, selon une direction parallèle à un plan d'extension principale de la face supérieure de la couche, d'une distance inférieure ou égale à la plus petite distance séparant deux motifs adjacents de différentes hauteurs. Ainsi, selon une direction parallèle au plan d'extension principale de la face supérieure, la distance sur **laquelle** l'épaisseur de résine varie lors du transfert de motif par le moule, est inférieure ou égale à la distance entre les motifs de hauteurs différentes. L'épaisseur de résine ne varie qu'entre deux zones où l'épaisseur de résine est constante.

Selon un exemple, le gradient d'épaisseur du masque d'implantation est configuré de sorte que les première et deuxième portions sont espacées, selon une direction parallèle au plan d'extension principale de la face supérieure de la couche, d'une distance inférieure ou égale à la plus petite distance séparant deux motifs adjacents de différentes hauteurs.

Selon un exemple, le masque d'implantation est configuré de sorte que les première et deuxième portions sont séparées par une portion intermédiaire dans laquelle la profondeur d'implantation varie. La portion intermédiaire présente ainsi un gradient de profondeur progressif entre les première et deuxième portions.

Selon un exemple, le gradient d'épaisseur du masque d'implantation est configuré de sorte que les première et deuxième portions sont séparées par une portion intermédiaire dans laquelle la profondeur d'implantation varie.

Selon un exemple, le masque d'implantation est configuré de sorte que les première et deuxième portions sont directement adjacentes. Les première et deuxième portions forment ainsi un gradient de profondeur abrupte entre $P_1$ et $P_2$.

Selon un exemple, le gradient d'épaisseur du masque d'implantation est configuré de sorte que les première et deuxième portions sont directement adjacentes.

Selon un exemple, l'implantation ionique est configurée de sorte que les première et deuxièmes portions prises ensemble s'étendent sur sensiblement dans tout le plan d'extension principale de la face supérieure de la couche.

Selon un exemple, préalablement à la gravure, le procédé comprend plusieurs implantations ioniques de façon à implanter une pluralité de premières portions et une pluralité de deuxièmes portions, les implantations ioniques étant configurées entre elles de sorte que :

- les premières portions diffèrent des deuxième portions par au moins un paramètres pris parmi : une nature des ions implantés, une dose en ions implantés, et/ou
- les première et deuxième portions présentent des profondeurs d'implantation $P_1$, $P_2$ différentes entre les premières portions et les deuxièmes portions.

Ainsi, le procédé permet d'implanter des premières portions et des deuxièmes portions dans la couche, de préférence de façon localisée. Selon la nature de l'ion et/ou la profondeur d'implantation, la vitesse de gravure est modulée pour obtenir des motifs de hauteurs différentes dans chacune des portions.

Selon un exemple, chaque portion implantée présente une seule profondeur d'implantation.

Selon un exemple, les portions implantées sont séparées les une des autre par la troisième portion non-implantée.

Selon un exemple, au moins un motif s'étend dans chacune des portions implantées.

Selon un exemple, au moins une parmi la première portion et la deuxième portion, de préférence la première portion et la deuxième portion, est/sont implantée(s) avec une dose d'implantation sensiblement comprise entre $10^{12}$ et $10^{15}$ at/cm$^2$.

Selon un exemple, les implantations ioniques sont configurées de sorte que chacune des premières et deuxièmes portions implantées s'étend, selon une direction parallèle à la direction principale d'extension de la face supérieure de la couche, sur une distance sensiblement égale à une dimension du motif réalisé durant la gravure, selon la même direction.

Selon un exemple, les implantations ioniques sont effectuées à travers le masque de gravure de sorte que chacune des premières et deuxièmes portions implantées s'étend au droit des ouvertures du masque de gravure.

Selon cette direction, les dimensions d'une portion implantée coïncident avec celles du motif à graver. La portion implantée permet ainsi de moduler les propriétés de la couche pour définir les contours du motif à la gravure.

Selon un exemple, la gravure est configurée pour graver sélectivement chaque portion implantée, au moins la deuxième portion et le cas échéant les première et deuxième portions, par rapport à la troisième portion non implantée. Ainsi, lors de la gravure, la portion non implantée forme une couche d'arrêt de la gravure. L'étape de gravure est rendue plus fiable et reproductible, en dépendant moins et de préférence en ne dépendant plus du temps de gravure.

Selon un exemple, la gravure est configurée de sorte que la vitesse de gravure de la portion implantée est au moins 100 fois supérieure à la vitesse de gravure de la portion non-implantée.

Selon un exemple, la gravure est configurée de façon à ne pas graver la portion non-implantée.

Selon un exemple, la gravure est stoppée après avoir consommé toute l'épaisseur de la deuxième portion située au droit des ouvertures du masque de gravure. La profondeur des motifs est ainsi contrôlée avec précision.

Selon un exemple, l'implantation ionique est configurée pour implanter au moins l'un parmi les ions oxygène, hydrogène, hélium, arsenic, phosphore et carbone, dans la couche.

Selon un exemple, la couche est à base ou faite d'au moins un parmi le silicium ou un matériau transparent à la longueur d'onde de 365 nm.

Selon un exemple, le procédé est tel H2>H1.

Selon un exemple, le procédé est tel H2<H1.

Selon un exemple la couche est faite de silicium.

Selon un exemple la couche est à base ou faite d'oxyde de silicium de formule $SiO_2$, de carbure de silicium de formule SiC.

Selon un exemple, le procédé comprend une unique étape de gravure.

Selon un exemple, le moule est un moule dit maître (généralement désigné par master), destiné à servir à la réalisation de moules secondaires pour nano-impression.

Selon un exemple, le moule est tel H2>H1.

Selon un exemple, le moule est tel H2<H1.

Selon un exemple, le moule est un moule maître et le volume total Vb des zones en creux définies par le deuxième ensemble de motifs est supérieur au volume total Va des zones en creux définies par le premier ensemble de motifs.

Selon un autre exemple, le moule est un moule « direct », destiné à être pressé dans une résine sans moule intermédiaire. Dans ce cas, le volume Vb des zones en creux définies par le deuxième ensemble de motifs est inférieur au volume total Va des zones en creux définies par le premier ensemble de motifs.

Selon un exemple, l'implantation est effectuée selon une direction d'implantation privilégiée perpendiculaire à la face supérieure.

Selon un exemple, dans le moule, la première portion implantée présente une première profondeur d'implantation $P_1$ et la deuxième portion implantée présente une deuxième profondeur d'implantation $P_2$, avec $P_2$ strictement supérieure à $P_1$ et $P_1$ nulle ou supérieure à 0.

Selon l'invention, la couche présente, dans la première portion un premier ensemble de motifs, et dans la deuxième portion un deuxième ensemble de motifs tels que :

- le premier ensemble de motifs présentant une première densité $D_1$ de motifs et une première hauteur $H_1$,
- le deuxième ensemble de motifs présentant une deuxième densité $D_2$ de motifs, et $D_2>D_1$ , et optionnellement $H_2>H_1$.

Selon un exemple, au moins une, et de préférence chacune, parmi les première et deuxième profondeurs d'implantation est supérieure ou égale à 30 nm.

Selon un exemple, au moins une, et de préférence chacune, parmi les première et deuxième profondeurs d'implantation est inférieure ou égale à 1 $\mu$m.

**De préférence,** moins une, et de préférence chacune, parmi les première et deuxième profondeurs d'implantation est comprise entre 30 nm et 1 $\mu$m.

Selon un exemple, les première et deuxième profondeurs d'implantation sont inférieures ou égale à 30 nm, de préférence inférieure ou égale à 10 nm.

Selon un exemple, les première et deuxième portions sont espacées, selon une direction parallèle au plan d'extension principale de la face supérieure de la couche, d'une distance inférieure ou égale à la plus petite distance séparant deux motifs adjacents de différentes hauteurs.

Il est précisé que dans le cadre de la présente invention, on entend par un substrat ou une couche, « à base » d'une espèce A, un substrat ou une couche comprenant cette espèce A uniquement ou cette espèce A et éventuellement d'autres espèces.

Un substrat comprenant une couche peut être :

- soit, préférentiellement, un empilement dans lequel le substrat comprend la couche déposée sur une couche de support,
- soit un substrat comprenant uniquement la couche. Dans ce cas, la couche peut être autoportante c'est-à-dire qu'elle supporte son propre poids.

Dans le cadre de la présente invention, on qualifie de matériau transparent à une longueur d'onde donnée, un matériau qui permet de transmettre au moins 70 % d'un flux lumineux de cette longueur d'onde donnée.

Plusieurs exemples de réalisation de l'invention mettant en œuvre des étapes successives du procédé de fabrication sont décrits ci-après. Sauf mention explicite, l'adjectif « successif » n'implique pas nécessairement, même si cela est généralement préféré, que les étapes se suivent immédiatement, des étapes intermédiaires pouvant les séparer.

Par ailleurs, le terme « étape » s'entend de la réalisation d'une partie du procédé, et peut désigner un ensemble de sous-étapes.

Par ailleurs, le terme « étape » ne signifie pas obligatoirement que les actions menées durant une étape soient simultanées ou immédiatement successives. Certaines actions d'une première étape peuvent notamment être suivies d'actions liées à une étape différente, et d'autres actions de la première étape peuvent être reprises ensuite. Ainsi, le terme étape ne s'entend pas forcément d'actions unitaires et inséparables dans le temps et dans l'enchaînement des phases du procédé.

Par dispositif microélectronique, on entend tout type de dispositif réalisé avec les moyens de la microélectronique. Ces dispositifs englobent notamment en plus des dispositifs à finalité purement électronique, des dispositifs micromécaniques ou électromécaniques (MEMS, NEMS...) ainsi que des dispositifs optiques ou optoélectroniques (MOEMS, LED...).

Il peut s'agir d'un dispositif destiné à assurer une fonction électronique, optique, mécanique etc. Il peut aussi s'agir d'un produit intermédiaire uniquement destiné à la réalisation d'un autre dispositif microélectronique.

Il est précisé que dans le cadre de la présente invention, l'épaisseur d'une couche ou du substrat se mesure selon une direction perpendiculaire à la surface selon laquelle cette couche ou ce substrat présente son extension maximale. L'épaisseur est ainsi prise selon une direction perpendiculaire aux faces principales de la couche, ou du substrat sur lequel repose les différentes couches. Sur les figures, l'épaisseur est prise selon la verticale.

Il est précisé que, dans le cadre de la présente invention, les termes « sur », « surmonte », « recouvre », « sous-jacent », en « vis-à-vis » et leurs équivalents ne signifient pas forcément « au contact de ». Ainsi par exemple, le dépôt, le report, l'assemblage ou l'application d'une première couche sur une deuxième couche, ne signifie pas obligatoirement que les deux couches sont directement au contact l'une de l'autre, mais signifie que la première couche recouvre au moins partiellement la deuxième couche en étant soit directement à son contact, soit en étant séparée d'elle par au moins une autre couche ou au moins un autre élément.

On entend par un paramètre « sensiblement égal/supérieur/inférieur à » une valeur donnée, que ce paramètre est égal/supérieur/inférieur à la valeur donnée, à plus ou moins 10 %, près de cette valeur. On entend par un paramètre « sensiblement compris entre » deux valeurs données que ce paramètre est au minimum égal à la plus petite valeur donnée, à plus ou moins 10 %, près de cette valeur, et au maximum égal à la plus grande valeur donnée, à plus ou moins 10 %, près de cette valeur.

Dans le cadre de la présente invention, on qualifie de résine imprimable un matériau organique ou organo-minéral pouvant être mis en forme mécaniquement par pressage par un moule comprenant des motifs. Une résine réticulable ou polymérisable est une résine imprimable qui a la faculté de réticuler ou de polymériser par exposition à un faisceau de photons, par exemple dans la gamme de l'ultraviolet et/ou par application d'une température. Ce type de résine est employé de manière conventionnelle dans les procédés d'impression nanométrique assistés par UV ou assistés thermiquement.

Dans le cadre de l'invention, les énergies sont données en électronvolt, pour lequel $1 \, eV \approx 1,602.10^{-19} \, J$, dans le système international des unités.

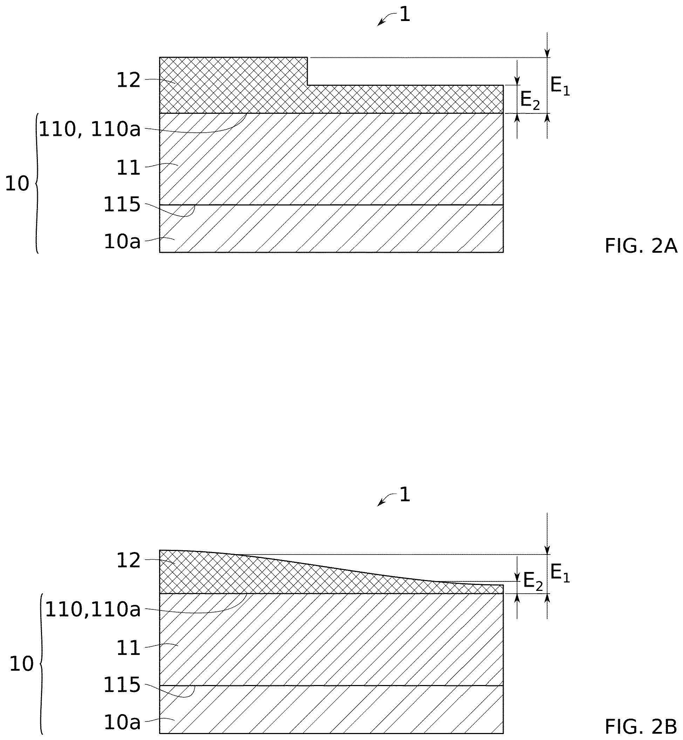

Plusieurs exemples non limitatifs de l'invention vont maintenant être décrits en détail en référence aux figures 2A à 7B.

Le procédé comprend la fourniture d'un substrat 10 comprenant une couche 11 présentant une face supérieure 110 et une face inférieure 115 opposée à la face supérieure 110. Dans les figures, on considère à titre non limitatif que le substrat 10 est un empilement comprenant une couche support 10a, qui peut être également désigné substrat de support, et la couche 11 surmontant la couche support 10a. On peut prévoir que le substrat 10 comprend uniquement la couche 11.

Le procédé comprend en outre une implantation ionique configurée de sorte que la couche 11 présente au moins une première portion 111 et au moins une deuxième portion 112, chacune de ces portions s'étendant depuis face supérieure 110. Les propriétés de ces portions sont différentes entre elles, de sorte qu'une gravure de motifs 114a, 114b à partir de chacune de ces portions 111, 112 donne des motifs 114a, 114b de hauteurs différentes.

Pour cela, l'implantation ionique est configurée de sorte que la première portion 111 n'est pas implantée ou présente une première implantation différente de la deuxième implantation. La deuxième portion 112 est implantée, et présente la deuxième implantation. Selon un exemple, la première implantation et la deuxième implantation diffèrent par, comme décrit ultérieurement plus en détail en référence aux figures :

- une profondeur d'implantation, et/ou
- une nature des ions implantés, et/ou
- une dose en ions implantées.

Pour cela, les paramètres d'implantation ionique peuvent être variés, et par exemple le type d'ions implantés, l'énergie d'implantation et/ou la dose d'ions implantée, de façon connue pour la personne du métier. En pratique l'implantation ionique induit dans le matériau implanté une extension latérale de la zone implantée de par les interactions (élastiques et inélastiques) entre les ions et le matériau implanté, ce qui se traduit par la présence d'une poire de diffusion des ions implantés, bien connue de la personne du métier. La forme géométrique de cette poire, à savoir la profondeur implantée et les éventuelles extensions latérales de cette dernière, dépend notamment :

- des conditions d'implantation : numéro atomique de l'ion implanté et de la tension d'accélération dans l'équipement ;
- des matériaux des couches déposées et le substrat utilisé qui vont impacter les intensités des interactions entre les ions et les matériaux implantés.

La personne du métier peut par exemple recourir à des outils connus tels que SRIM (abrégé de l'anglais *Stopping and Range* of *Ions in Matter,* pouvant être traduit par « arrêt et portée des ions dans la matière ») ou TRIM (abrégé de l'anglais *TRansport* of *Ions in Matter,* pouvant être traduit par « «transport des ions dans la matière ») qui permettent de simuler les interactions entre des ions et le matériau de la couche 11.

L'implantation ionique définie en outre dans la couche 11 une troisième portion 113 non implanté s'étendant au moins depuis la première portion 111, et de préférence depuis les première 111 et deuxième 112 portions jusqu'à la face inférieure 115 de la couche 11. La troisième portion 113 s'étend plus particulièrement au droit de la première portion 111 uniquement, ou au droit des première 111 et deuxième 112 portions. Selon un exemple, la deuxième portion 112 s'étend jusqu'à la face inférieure 150 de la couche 11.

Avant ou après l'implantation, un masque de gravure 13 est réalisé sur la face supérieure 110. Le masque de gravure 13 présente une pluralité d'ouvertures 130a, 130b à partir desquels les motifs du moule 1 seront formés dans l'étape de gravure.

Après la réalisation du masque de gravure 13 et après l'implantation, le procédé comprend en outre une gravure de la couche 11 configurée de façon à présenter une vitesse de gravure différente entre au moins la deuxième portion 112 et la troisième portion 113. La gravure peut être une gravure humide ou de préférence une gravure sèche, par exemple une gravure par plasma ou une gravure ionique réactive (communément abrégé RIE, de l'anglais « *Reative Ion Etching* »).

Selon un exemple, la gravure de la couche 11 est configurée de façon à présenter une vitesse de gravure différente entre l'ensemble formé par les première 111 et deuxième 112 portions, et la troisième portion 113. Selon un autre exemple, la gravure de la couche 11 est configurée de façon à présenter une vitesse de gravure différente entre chacune parmi la première portion 111, la deuxième portion 112 et la troisième portion 113.

La gravure est configurée pour former au moins un motif 114a s'étendant dans la première portion 111 et au moins un motif 114b s'étendant dans la deuxième portion 112, depuis la face supérieure 110. Les motifs 114a, 114b peuvent s'étendre uniquement dans la première portion 111 et/ou deuxième portion 112. Les motifs 114a, 114b peuvent s'étendre respectivement dans la première 111 et deuxième portion 112, et dans la troisième portion 113 s'étendant entre la première 111 et/ou deuxième portion 112 et la face inférieure 150 de la couche 11. Les motifs sont des formes en creux s'étendant de préférence au droit de la face supérieure 110, depuis cette face 110, gravés à travers les ouvertures 130a, 130b du masque de gravure 13. Les motifs sont formés aux droits des parois délimitées par les ouvertures 130b, 130b du masque de gravure 13.

Les différentes vitesses de gravure permettent de graver des motifs différents entre les première 111 et deuxième 112 portions, et plus particulièrement des motifs de différentes hauteurs dans la couche 11, la hauteur étant prise depuis la face supérieure 110, ou de façon équivalente depuis les sommets des motifs 114a, 114b, jusqu'au fond des motifs, selon une direction perpendiculaire au plan d'extension principale de la face supérieure 110. Dans les figures, la hauteur des motifs est prise selon la verticale.

Selon un exemple préféré, la vitesse de gravure de la deuxième portion 112 est strictement supérieure à la vitesse de gravure d'une portion non-implantée de la couche 11, et notamment la troisième portion 113. Une portion non-implantée forme ainsi une couche de freinage, voire une couche d'arrêt, de la gravure, permettant de mieux contrôler la hauteur des motifs 114a, 114b gravés. Selon un exemple la vitesse de gravure de l'ensemble formé par les première 111 et deuxième 112 portions est strictement supérieure à la vitesse de gravure de la troisième portion 113. Selon un autre exemple la vitesse de gravure de chacune parmi la première portion 111 et la deuxième portion 112 est strictement supérieure à la vitesse de gravure de la troisième portion 113 non implantée, les vitesses de gravure entre la première portion 111 et la deuxième portion 112 pouvant différer.

Selon un exemple, on cherche à graver un premier ensemble de motif 114a présentant une première densité, et un deuxième ensemble de motif 114b présentant une deuxième densité. Dans le cadre de cette invention, par le terme « densité », on désigne le la surface ou le volume occupé par les formes en creux que constituent les motifs 114a, 114b dans la couche 11, sur une surface donnée prise selon une section des motifs parallèlement à la face supérieure 110 ou la face inférieure de la couche 11. Une faible densité correspond à un ensemble de motifs présentent un faible volume en creux sur la surface donnée. Une forte densité correspond à un ensemble de motifs présentent un grand volume en creux sur une surface de même dimension.

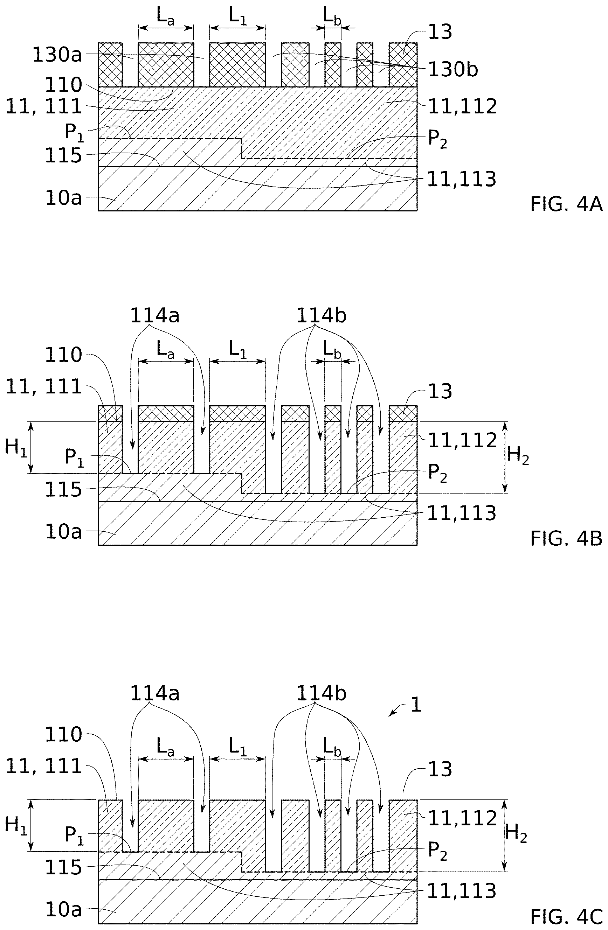

Par exemple, comme illustré par les figures 4C, 5C et 6D :

- des motifs compacts présentent une forte densité, et sont donc espacés par une distance $L_b$ plus petite,
- des motifs espacés présentent une faible densité, et sont donc espacés par une distance $L_a$ plus grande.

Notons que la densité désigne ici une densité moyenne sur une surface donnée. Des variations entre les distances $L_a$ et/ou $L_b$ peuvent être observées dans un même ensemble de motifs. $L_a$ ne varie pas de plus de 20% entre les motifs 114a pour le premier ensemble. $L_b$ ne varie pas de plus de 20% entre les motifs 114b pour le deuxième ensemble.

Lors du transfert des reliefs du moule 1 dans la couche à imprimer pour former les motifs, afin d'obtenir une épaisseur résiduelle de résine plus homogène entre les ensembles de motifs de différentes densités, la hauteur entre les ensembles de motifs peut être variée.

Selon l'invention, l'implantation des première 111 et deuxième 112 portions et la gravure sont configurées de sorte que :

- le premier ensemble de motifs 114a présente une première densité $D_1$ de motifs et une première hauteur $H_1$,
- le deuxième ensemble de motifs 114b présente une deuxième densité $D_2$ de motif, et une deuxième hauteur $H_2$, avec $D_2 > D_1$, et optionnellement $H_2 > H_1$.

$H_1$ et $H_2$ désignent chacune une hauteur moyenne de motif pour l'ensemble correspondant. $H_1$ ne varie pas de plus de 20% entre les motifs 114a pour le premier ensemble. $H_2$ ne varie pas de plus de 20% entre les motifs 114b pour le deuxième ensemble.

Pour cela, le premier ensemble de motifs 114a peut être gravé dans la ou les premières portions 111, et le deuxième ensemble de motifs 114b peut être gravé dans la ou les deuxièmes portions 112. La différence de vitesse de gravure décrite ci-dessus permet ainsi d'adapter la hauteur des motifs en fonction de la densité des ensembles de motifs et ainsi d'améliorer encore l'homogénéité de la couche de résine résiduelle lors de la nanoimpression avec le moule 1.

A titre d'exemple, dans le cas où les motifs 114a, 114b sont des réseaux de lignes, l'épaisseur résiduelle $H_{résiduelle}$ de résine après impression par le moule, par exemple le moule maître ou un moule secondaire fait à partir d'un moule maître, peut s'exprimer ainsi :

$$H_{résiduelle} = H_{initiale} - H_{moule(n)} / (1+L/S)$$

Avec :

- L la largeur des lignes sur le moule,
- S la largeur des espaces sur le moule,
- $H_{moule(n)}$ la profondeur des motifs n du moule,

- $H_{initiale}$ l'épaisseur de résine initiale.

Pour deux densités différentes $D_1$, $D_2$ de motif, le rapport L/S est différent. Afin d'obtenir la même l'épaisseur résiduelle $H_{résiduelle}$ de résine après impression par le moule, le moule doit présenter deux hauteurs de motifs $H_{moule(1)}$, $H_{moule(2)}$ différentes. Le procédé est donc mis en oeuvre de sorte que $E_1$ correspond à $H_{moule(1)}$, et $E_2$ correspond $H_{moule(2)}$.

Chaque motif 114a, 114b présente en outre un volume de motif correspondant au volume de la zone en creux définie par les motif 111a, 114b en question dans la couche 11. Chaque ensemble de motifs 114a, 114b présente un volume total Va, Vb respectivement, correspondant à la somme des volumes en creux de motif des motifs 114a, 114b le constituant. Le volume total Va, Vb dépend de la hauteur H1, H2 et de la densité D1, D2 des motifs 114a, 114b. Augmenter la hauteur H1, H2 ou la densité D1, D2 des motifs 114a, 114b a pour conséquence d'augmenter le volume Va, Vb des ensembles de motifs 114a, 114b.

Lors de l'étape de nanoimpression, le volume de résine pouvant être accueilli par un ensemble de motifs 114a, 114b est égal au volume total Va, Vb de ce dernier. Ainsi, pour que l'épaisseur de la couche résiduelle soit homogène, il faut que le ratio Va/Vb entre les volumes totaux Va, Vb soit correctement défini, et notamment qu'il soit judicieusement choisi si Va>Vb ou si Va<Vb. L'implantation des première 111 et deuxième 112 portions et la gravure sont configurées pour que les valeurs de ces volumes totaux Va, Vb soient telles que la résine se répartisse de façon satisfaisante entre les différents ensembles de motifs 114a, 114b. Naturellement, le dimensionnement de Va et de Vb devra prendre en compte si le moule fabriqué est destiné à être utilisé pour la fabrication d'un moule secondaire, ou s'il est destiné à imprimer directement une résine.

Suite à la gravure, le procédé peut comprendre le retrait du masque de gravure 13 pour obtenir le moule 1. Le procédé peut comprendre, avant le retrait du masque de gravure 13, une étape préliminaire de traitement thermique pour la compatibilité des matériaux avec l'étape de retrait.

L'on comprend donc que le moule 1 comprend dans la couche 11 portant les motifs 114a, 114b destinés à être imprimés dans une couche à structurer sur un substrat distinct, au moins une première portion 111 non implantée ou présentant une première implantation, et au moins une deuxième portion 112 présentant une deuxième implantation différente de la première implantation. Les première 111 et deuxième 112 portions s'étendant chacune depuis ladite face supérieure 110. La couche comprend en outre une troisième portion 113 non implantée s'étendant au moins depuis la première portion 111, et de préférence depuis les première 111 et deuxième 112 portions, jusqu'à la face inférieure 115 de la couche 10. On décrit les caractéristiques relativement au procédé de fabrication du moule. Ces caractéristiques peuvent tout à fait être transposées au moule 1.

De préférence, le moule 1 est un moule maître destiné à réaliser une nano-impression de motifs par réplication indirecte. On peut toutefois prévoir que le moule 1 soit utilisé pour une nano-impression par réplication directe.

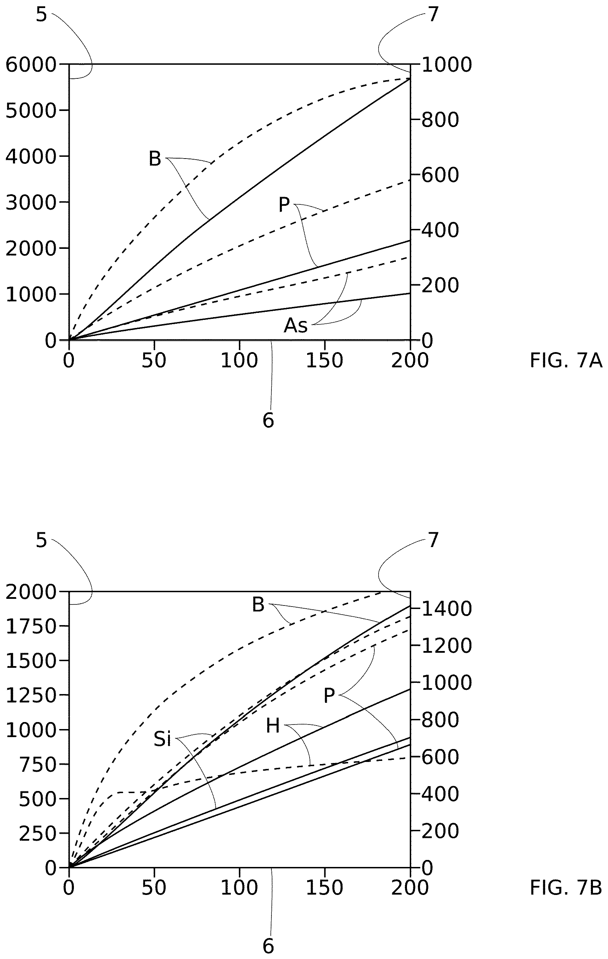

L'implantation ionique peut être configurée pour implanter au moins l'un parmi les ions oxygène, hydrogène, hélium, arsenic, phosphore, zinc et carbone, dans la couche 11. L'implantation ionique de ces ions, ainsi que les paramètres pour cela, est connue de l'homme du métier. On peut par exemple faire référence aux figures 7A et 7B, représentent des diagrammes d'implantation d'ions respectivement dans de la silice $SiO_2$ et dans une photo-résine, disponibles dans la littérature pour de nombreux ions et différents matériaux. Ces diagrammes représentent en trait plein la distance parcourue 5 (en angström Å $10^{-10}$ m) dans la matière par les ions, selon l'énergie d'implantation 6 (en keV, soit $10^3$ eV), avec en pointillé la plage de distribution de la distance parcourue par les ions pendant l'implantation 7 (communément désignée par le symbole $\sigma$), selon l'énergie d'implantation 6 (en keV, soit $10^3$ eV). En figure 7A, les ions illustrés sont des ions de bore B, de phosphore P et d'arsenic As. En figure 7B, les ions illustrés sont des ions de bore B, de silicium Si, d'hydrogène H et de phosphore P. La personne du métier, à la lecture de tels diagrammes, saura quels paramètres et notamment quelle énergie d'implantation utiliser pour adapter les profondeurs $P_1$ et $P_2$.

Selon un exemple, la couche 11 est à base ou faite de silicium et/ou d'un matériau transparent à la longueur d'onde de 365 nm. Selon un exemple la couche est faite de silicium. Concernant les matériaux transparents à la longueur d'onde de 365 nm, selon un exemple la couche est à base ou faite d'oxyde de silicium de formule $SiO_2$, de carbure de silicium de formule SiC, de préférence la couche présente alors une épaisseur inférieure ou égale à 100 $\mu$m. Selon un autre exemple la couche est à base ou faite de nitrure de silicium de formule $Si_3N_4$, de préférence la couche présente alors une épaisseur inférieure ou égale à 10 nm.

Le masque d'implantation 12 peut être à base ou fait d'une résine de lithographie. Le masque d'implantation peut comprendre une sous-couche à l'interface entre la résine et la face supérieure 110, dit masque de transmission partielle à base ou faite de nitrure de titane de formule TiN ou de nitrure de silicium de formule $Si_3N_4$. Le masque de gravure 13 peut être à base ou fait des mêmes matériaux que le masque d'implantation 12.

Exemples particuliers de réalisation du procédé

Des exemples particuliers de réalisation du procédé sont maintenant décrits.

Selon un exemple illustré par les figures 2A à 5C, le procédé peut comprendre la réalisation d'un masque d'implantation 12 sur au moins une portion 110a de la face supérieure 110 de la couche 11. Comme illustré par exemple par les figures 2A et 2B, la réalisation du masque d'implantation 12 peut être configurée de sorte que le masque d'implantation 12 présente un gradient d'épaisseur entre au moins une première épaisseur $E_1$ et une deuxième épaisseur $E_2$, avec $E_1$ strictement supérieure à $E_2$ et $E_2$ nulle ou strictement supérieure à 0. Le masque d'implantation 12 crée ainsi un différentiel d'épaisseur au-dessus de la couche 11. Dans les figures 2A et 2B, on illustre à titre non limitatif l'exemple selon lequel l'épaisseur $E_2$ est non-nulle.

L'implantation ionique peut être réalisée à travers le masque d'implantation 12. Grâce au différentiel d'épaisseur du masque d'implantation 12, la première portion implantée 111 peut présenter une première profondeur d'implantation $P_1$ et la deuxième portion implantée 112 peut présenter une deuxième profondeur d'implantation $P_2$, avec $P_2$ strictement supérieure à $P_1$ et $P_1$ nulle ou supérieure à 0. On considère le trajet des ions selon une direction privilégiée perpendiculaire au plan d'extension principale de la face supérieure 110 de la couche 11.

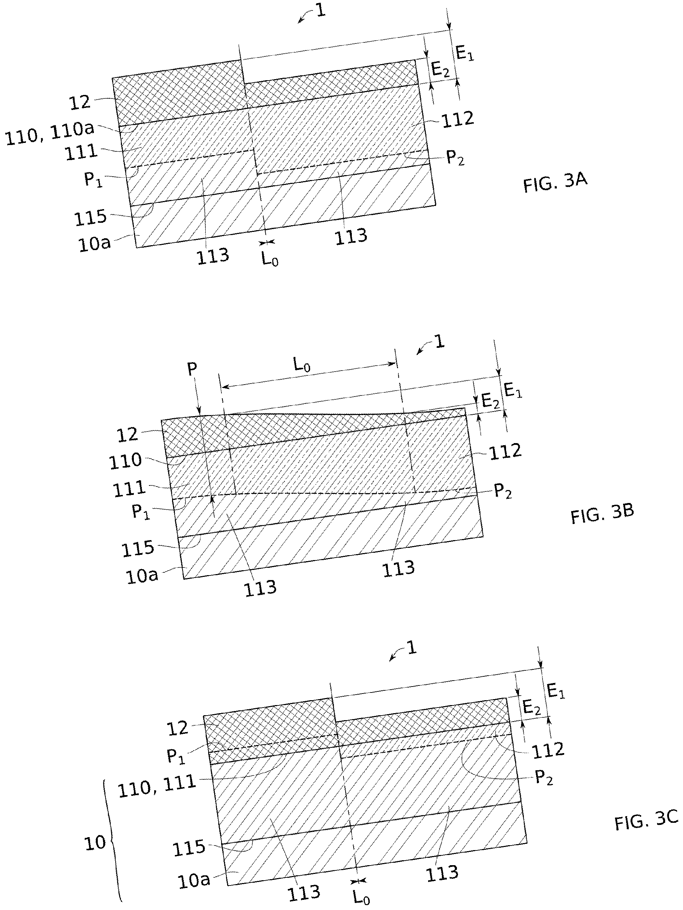

Selon l'exemple illustré par les figures 3A et 3B, on a $P_2 > P_1 > 0$. Ainsi, la première portion 111 est implantée jusqu'à la première profondeur $P_1$, et la deuxième portion 112 est implantée jusqu'à la deuxième profondeur $P_2$. La troisième portion 113 peut s'étendre depuis la première profondeur $P_1$, et de préférence depuis les première et deuxième profondeurs $P_1$, $P_2$, jusqu'à la face inférieure 150 de la couche 11. Selon un exemple toute la face supérieure 110 de la couche 11 est implantée, à des profondeurs différentes.

Pour cela, l'implantation ionique peut être configurée pour implanter la couche 11 à travers le masque d'implantation 12 de sorte que les ions implantés traversent le masque d'implantation 12 et pénètrent dans la couche 11, sur une distance supérieure à $E_1$ et $E_2$ prise perpendiculairement à la face supérieure 110 de la couche 11.

L'implantation ionique peut pour cela être configurée de sorte qu'au moins une, et de préférence chacune, parmi les première $P_1$ et deuxième $P_2$ profondeurs d'implantation est supérieure à 30 nm, et de préférence inférieure à 1 $\mu$m. La distance parcourue par les ions suite à leur pénétration dans le masque d'implantation 12 peut être supérieure à 30 nm, et de préférence inférieure à 1 $\mu$m. L'implantation ionique peut plus particulièrement être réalisée par un dispositif implanteur, de façon connue par la personne du métier.

Selon l'exemple illustré par la figure 3C, on a $P_2 > P_1$ et $P_1 = 0$ par rapport au niveau de la face supérieure 110 de la couche 11. Ainsi, la première portion 111 présente une profondeur d'implantation $P_1$ nulle au niveau de la couche 11. La première portion 111 n'est donc pas implantée dans la couche 11 et peut être confondue avec la troisième portion 113 non implantée. La deuxième portion 112 est implantée jusqu'à la deuxième profondeur $P_2$ non nulle, dans la couche 11. La troisième portion 113 peut s'étendre depuis la deuxième profondeur $P_2$,

jusqu'à la face inférieure 150 de la couche 11. Ainsi, une fraction de la face supérieure 110 n'est pas implantée.

Pour cela, l'implantation ionique peut être configurée pour implanter la couche 11 à travers le masque d'implantation 12 de sorte que les ions implantés traversent le masque d'implantation 12 sur une distance inférieure à $E_1$ et ne pénètrent pas dans la couche 11 au niveau de la première portion 111. Selon cet exemple, les ions implantés traversent le masque d'implantation 12 sur une distance supérieure à $E_2$ et pénètrent dans la couche 11 au niveau de la deuxième portion 112.

L'implantation ionique peut pour cela être configurée de sorte les première $P_1$ et deuxième $P_2$ profondeurs d'implantation sont inférieures à 30 nm, de préférence inférieure à 10 nm. La distance parcourue par les ions suite à leur pénétration dans le masque d'implantation 12 peut être sont inférieures à 30 nm, de préférence inférieure à 10 nm. L'implantation ionique peut plus particulièrement être réalisée par un plasma, et notamment par immersion du substrat 10 dans un plasma, de façon connue par la personne du métier.

Selon un exemple, la première épaisseur $E_1$ est sensiblement comprise entre 50 nm et 100 $\mu$m. Selon un exemple, la deuxième épaisseur $E_2$ est sensiblement comprise entre 0 nm et E1. Ces dimensions sont notamment choisies en fonction du design du moule et de l'application visée. Selon un exemple, le gradient d'épaisseur du masque est sensiblement égal à la différence de profondeur entre $P_1$ et $P_2$.

Le masque d'implantation 12, pour présenter ce gradient d'épaisseur, peut par exemple être réalisé par lithographie à niveaux de gris, ou des méthodes alternatives comme la lithographie par champ proche, par exemple par l'équipement NanoFrazor™ et le procédé associé. Le choix de la technologie adaptée dépendra des tolérances sur la distance $L_0$ qui sépare des ensembles de motifs de hauteurs différentes, selon une direction parallèle au plan d'extension principale de la face supérieure 110.

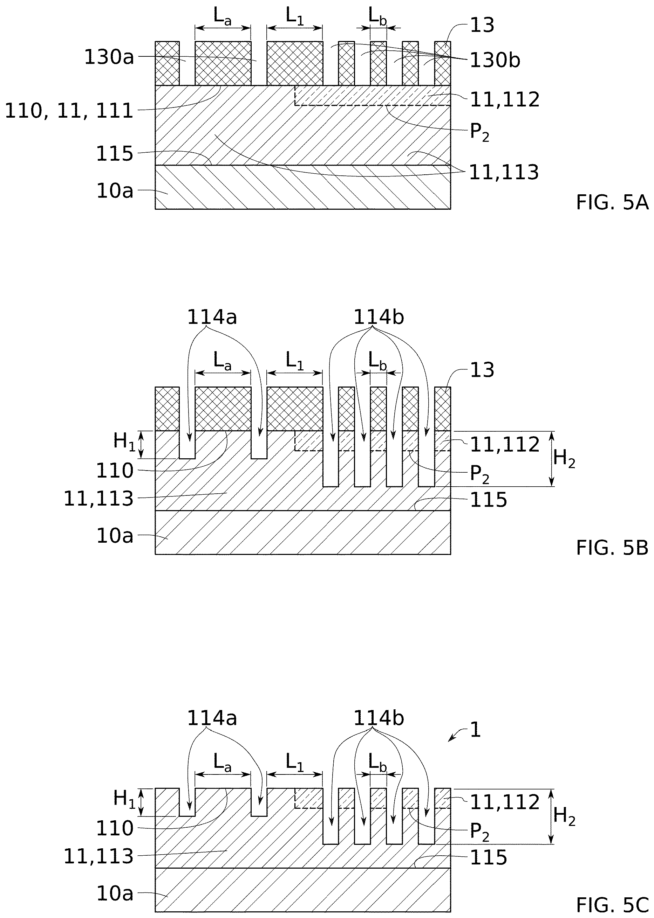

Selon un exemple, le masque d'implantation 12 est configuré de sorte que les première 111 et deuxième 112 portions sont espacées, selon une direction parallèle au plan d'extension principale de la face supérieure 110, d'une distance $L_0$ inférieure à la plus petite distance $L_1$ séparant deux motifs 114a, 114b adjacents de différentes hauteurs, et plus particulièrement séparant un premier ensemble de motifs 114a et un deuxième ensemble de motifs 114b, comme l'illustrent les figures 3A à 3C en comparaison avec les figures 4C et 5C.

Comme illustré par la figure 3B, le masque d'implantation 12 peut présenter un gradient d'épaisseur progressif entre $E_1$ et $E_2$, sur la longueur $L_0$. Notons que $E_2$ peut être nulle, le masque d'implantation 12 ne recouvrant qu'une fraction 110a de la face supérieure 110, ou être supérieure strictement à 0. Suite à l'implantation ionique, les première 111 et deuxième 112 portions peuvent ainsi être séparées par une portion intermédiaire 116, selon une direction parallèle au plan d'extension principale de la face supérieure 110. Dans cette portion intermédiaire 116, la profondeur d'implantation peut varier entre $P_1$ et $P_2$ pour former un gradient de profondeur progressif. Notons qu'on peut prévoir que $P_1$ soit nulle, ou strictement supérieure à 0 comme illustré, selon les exemples décrit précédemment. De préférence $L_0$ est sensiblement inférieure ou égale à la plus petite distance séparant les première et deuxième portions. Comme illustré par les figures 3A et 3C, le masque d'implantation 12 peut présenter un gradient d'épaisseur abrupte entre $E_1$ et $E_2$, sur une longueur $L_0$ par exemple sensiblement inférieure ou égale à la plus petite distance séparant les première et deuxième portions. Notons que, ici encore, $E_2$ peut être nulle ou être supérieure strictement à 0. Suite à l'implantation ionique, les première 111 et deuxième 112 portions peuvent ainsi être directement adjacentes selon une direction parallèle au plan d'extension principale de la face supérieure 110.

Selon un exemple, le procédé comprend un retrait du masque d'implantation 12 après l'implantation et avant l'étape de gravure, de préférence avant la réalisation du masque de gravure 13.

Selon un exemple, le masque de gravure 13 est réalisé après l'implantation ionique, comme illustré par exemple par le passage des figures 3A et 3C aux figures 4A et 5A. Lors de la gravure, les portions implantées de la couche 11 présentent de préférence une vitesse de gravure plus élevée que les portions non implantées.

Comme illustré par exemple par les figures 4A et 5A, le masque de gravure 13 peut présenter des ouvertures 130a et 130b délimitant des ouvertures correspondant aux motifs 114a et 114b à graver dans la couche 11. Une distance $L_1$ peut séparer l'ensemble de motifs 114a et l'ensemble de motifs 114b, de densités de motifs différentes, par exemple symbolisées par les longueurs $L_a$ et $L_b$. La différence de vitesse de gravure entre les portions implantées et les portions non implantées entraine la gravure de motifs 114a, 114b de hauteurs différentes, comme illustré par les figures 4B et 5B. Suite à la gravure, le procédé peut comprendre le retrait du masque de gravure 13, pour obtenir le moule 1 illustré par les figures 4C et 5C

Un exemple de gravure est maintenant décrit en référence aux figures 4A à 4C. La gravure peut être effectuée sur une durée de gravure choisie de sorte que toute l'épaisseur de la deuxième portion 112 est consommée au droit des ouvertures 130b du masque de gravure 13, de préférence sans consommer la troisième portion 113. La première portion 111 présentant une profondeur $P_1$ inférieure à la profondeur $P_2$ de la deuxième portion 112, et la troisième portion 113 présentant une vitesse de gravure inférieure, la hauteur des motifs 114a sera inférieure à la hauteur des motifs 114b dans la deuxième portion 112. La profondeur des motifs est ainsi contrôlée avec précision avec le temps de gravure.

Selon un exemple, la gravure est configurée pour graver sélectivement chaque portion implantée par rapport à la troisième portion non implantée 113. La gravure peut être configurée de sorte que toute l'épaisseur des première 111 et deuxième 112 portions est consommée au droit des ouvertures 130b du masque de gravure 13. Ainsi, la portion non implantée 113 forme une couche d'arrêt de la gravure. Seule les première 111 et deuxième 112 portions sont gravées de façon significative, ce qui permet un arrêt contrôlé de la gravure. Le contrôle de la profondeur des motifs 114a, 114b est ainsi encore amélioré.

Un exemple de gravure est maintenant décrit en référence aux figures 5A à 5C. La deuxième portion 112 peut présenter une vitesse de gravure supérieure à celle de la troisième portion 113. La gravure peut être effectuée sur une durée de gravure choisie de sorte que toute l'épaisseur de la deuxième portion 112 est consommée au droit des ouvertures 130b du masque de gravure 13, ainsi qu'une partie de la troisième portion 113. La deuxième portion 112 étant consommée plus rapidement, un différentiel de hauteur peut être obtenu entre les motifs 114a de hauteur $H_1$ et les motifs 114b de hauteur $H_2$ pour un même temps de gravure, comme illustré par la figure 5B. Notons qu'on peut prévoir que la deuxième portion 112 présente une vitesse de gravure inférieure à celle de la troisième portion 113, le différentiel de hauteur étant alors inversé.

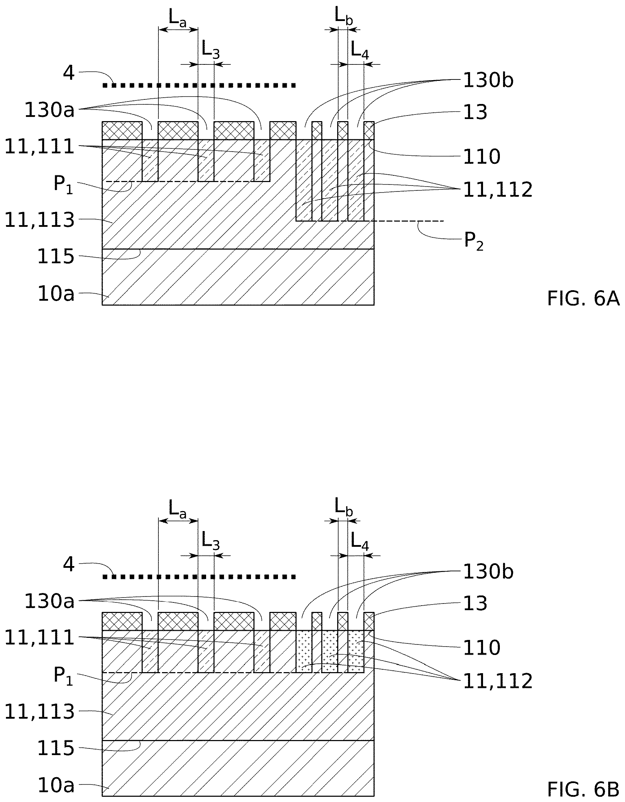

Un autre exemple de réalisation du procédé est maintenant décrit en référence aux figures 6A à 6D. Le procédé peut comprendre plusieurs implantations ioniques de façon à implanter une pluralité de premières portions 111 et une pluralité de deuxièmes portions 112. Chaque portion implantée peut être séparée de la portion implantée adjacente par une troisième portion 113 non implantée. Les implantations ioniques sont ainsi réalisées de façon localisée dans la couche 11.

Pour cela, le procédé peut comprendre la réalisation du masque de gravure 13, le masque de gravure présentant les ouvertures 130a, 130b correspondant aux motifs 114a, 114b à graver. L'implantation ionique peut être effectuée à travers le masque de gravure 13 et être configurée de sorte que les portions implantées 111, 112 s'étendent dans la couche 11 au droit des ouvertures 130a, 130b. Chacune des premières et deuxièmes portions implantées 111, 112 peut s'étendre, selon une direction parallèle à la direction principale d'extension de la face supérieure 110, sur une distance $L_3$, $L_4$ sensiblement égale à une dimension $L_3$, $L_4$ du motif 114a, 114b correspondant réalisé durant la gravure, selon la même direction. Les longueurs $L_3$, $L_4$ sont de préférence sensiblement égales à la distance entre les parois délimitant les ouvertures 130a, 130b, selon cette direction.

Les implantations ioniques peuvent être configurées entre elles de sorte que les premières portions 111 diffèrent des deuxième portions 112 par :

- leurs profondeurs d'implantation $P_1$, $P_2$, comme par exemple illustré par la figure 6A, et/ou
- une nature des ions implantés, et/ou une dose en ions implantés, comme par exemple illustré par la figure 6B.

Les premières portions 111 peuvent correspondre au premier ensemble de motifs 114a décrit précédemment. Les deuxièmes portions 112 peuvent correspondre au deuxième ensemble de motifs 114b décrit précédemment.

Les implantations ioniques peuvent être réalisées par un implanteur. L'implanteur peut comprendre des lames 4 (communément désignées par le terme anglais « *blade* ») mobiles de façon à masquer une partie du masque de gravure 13. Lors d'une première implantation ionique, la lame 4 peut masquer les ouvertures 130b de façon à n'implanter que les premières portions 111. Lors d'une deuxième implantation ionique, la lame 4 peut masquer les ouvertures 130a de façon à n'implanter que les deuxièmes portions 112. Ainsi, les portions 111, 112 peuvent être successivement implantées sans nécessiter de multiples étapes de dépôt d'un masque de gravure 13 et d'implantations pour chaque type de portions implantées.

Comme illustré par la figure 6A, les premières portions 111 peuvent différer des deuxièmes portions 112 par leur profondeur d'implantation, avec P1 < P2. La gravure peut être effectuée sur une durée de gravure choisie de sorte que toute l'épaisseur des deuxièmes portions 112 est consommée au droit des ouvertures 130b du masque de gravure 13, de préférence sans consommer la troisième portion 113. Les premières portions 111 présentant une profondeur P1 inférieure à la profondeur P2 de la deuxième portion 112, la hauteur des motifs 114a sera inférieure à la hauteur des motifs 114b dans les deuxièmes portions 112. La profondeur des motifs est ainsi contrôlée avec précision avec le temps de gravure.

Selon un exemple préféré, la gravure est configurée pour graver sélectivement chaque portion implantée 111, 112 par rapport à la troisième portion non implantée 113. La gravure peut être configurée sorte que toute l'épaisseur des premières 111 et deuxièmes 112 portion 11 est consommée au droit des ouvertures 130b du masque de gravure 13. Ainsi, la portion non implantée 113 forme une couche d'arrêt de la gravure. Seule les premières 111 et deuxièmes 112 portions sont gravées de façon significative, ce qui permet un arrêt contrôlé de la gravure. Cela peut à titre d'exemple être illustré le passage de la figure 6A à la figure 6C. Le contrôle de la profondeur des motifs 114a, 114b est ainsi encore amélioré.

Comme illustré par la figure 6B, les premières portions 111 peuvent différer des deuxièmes portions 112 par la nature des ions implantés et/ou la dose implantée, pour une même profondeur P1 comme illustré ou des profondeurs d'implantation différentes. La gravure peut être effectuée sur une durée de gravure choisie de sorte que toute l'épaisseur des deuxièmes portions 112 est consommée au droit des ouvertures 130b du masque de gravure 13, et consommer au moins une partie de la troisième portion 113. Les premières portions 111 peuvent présenter une vitesse de gravure inférieure à celle des deuxièmes portions 112. Les deuxièmes portions 112 étant consommée plus rapidement, un différentiel de hauteur peut être obtenu entre les motifs 114a de hauteur $H_1$ et les motifs 114b de hauteur $H_2$ pour un même temps de gravure, comme illustré par le passage de la figure 6B à la figure 6C. Notons qu'on peut prévoir que les deuxièmes portions 112 présentent une vitesse de gravure inférieure à celle des premières portions 111, le différentiel de hauteur étant alors inversé.

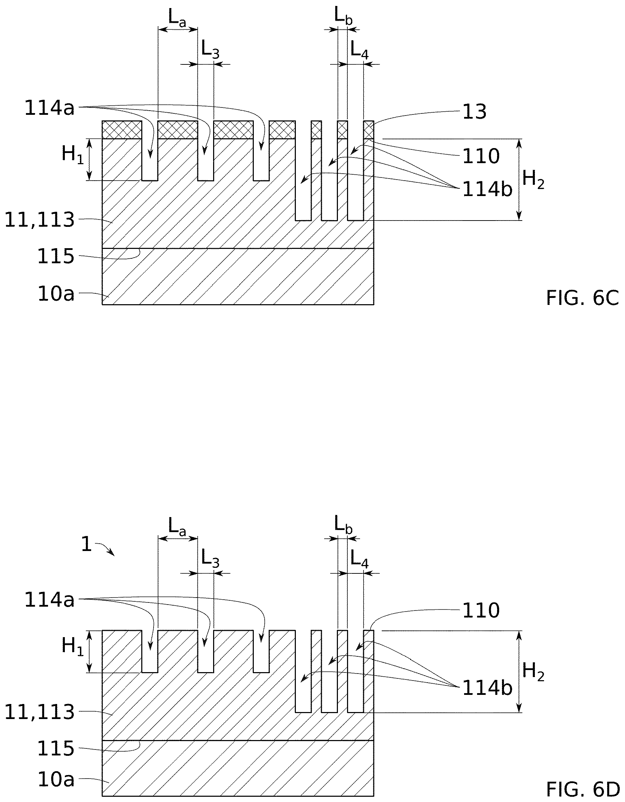

Comme indiqué ci-dessus et illustré par le passage de la figure 6C à la figure 6D, le masque de gravure 13 peut être retiré après la réalisation des motifs 114a et 114b.

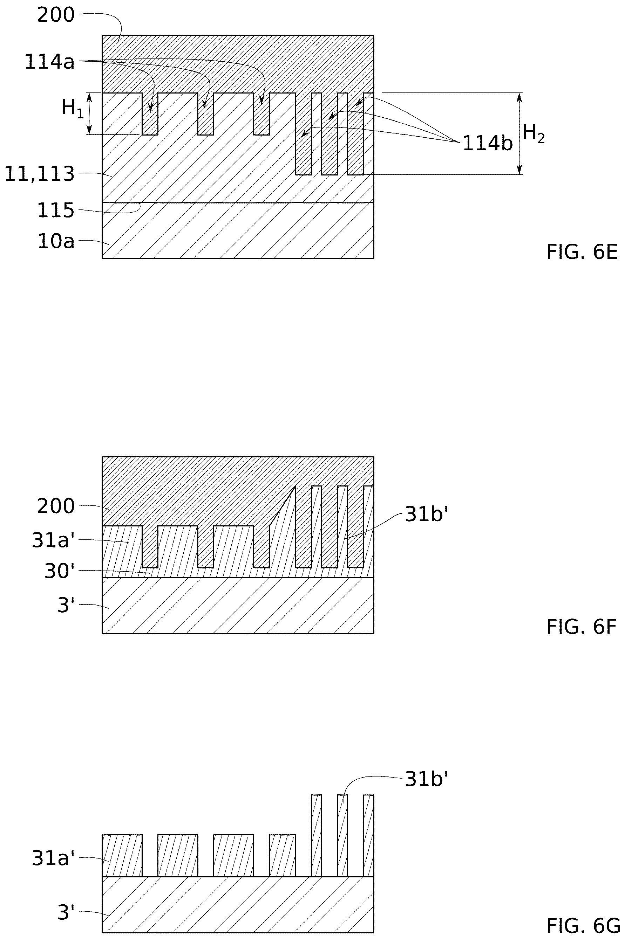

La figure 6D illustre tout particulièrement un moule 1 destiné à servir de moule maître dans un procédé de nano-impression. Comme illustré à la figure 6E, il peut en effet servir à la confection d'un moule secondaire 200 présentant des motifs inverses, qui eux seront imprimés dans la résine à structurer. Sur la figure 6E, le moule maître 1 est représenté sous le moule secondaire 200 par souci de clarté et d'homogénéité avec les figures précédentes. Naturellement, dans le cadre de la réalisation du moule secondaire 200, lors de l'étape de pressage, le moule maître 1 pourra être placé au-dessus d'une couche déformable destinée à former le moule secondaire 200 et pressé dans cette dernière. Dans cette application, les dimensions des ouvertures 130a dans le masque de gravure et les paramètres d'implantation notamment seront choisis tels le volume total Vb des zones en creux définies par le deuxième ensemble de motifs 114b est supérieur au volume total Va des zones en creux définies par le premier ensemble de motifs 114a. Va étant la surface occupée par les creux des motifs 114a du premier ensemble, surface prise dans un plan horizontal sur les figures 6A à 6E, et Vb étant la surface occupée par les creux des motifs 114b du deuxième ensemble, surface prise dans un plan horizontal sur les figures 6A à 6E. Selon l'invention, la densité du deuxième ensemble de motifs 114b est telle que D2>D1, avec comme condition sur la hauteur des motifs de préférence H2>H1 ou H2<H1 tant que Vb>Va. On peut également prévoir, selon une variante ne faisant pas partie de l'invention, que D2<D1 et H2>H1 tant que Vb>Va. Les dimensions D1, D2, H1 et H2 étant prises sur le moule maître 1. De cette façon, comme représenté à la figure 6F, lors de la nano-impression du moule secondaire 200 dans une couche de résine, la résine se répartit de telle sorte que la couche résiduelle 30' présente une épaisseur homogène. Cela permet de conserver les dimensions critiques des motifs 31a', 31b' lors de leur gravure dans le substrat 3', ou tout du moins limiter leur dégradation (figure 6G).

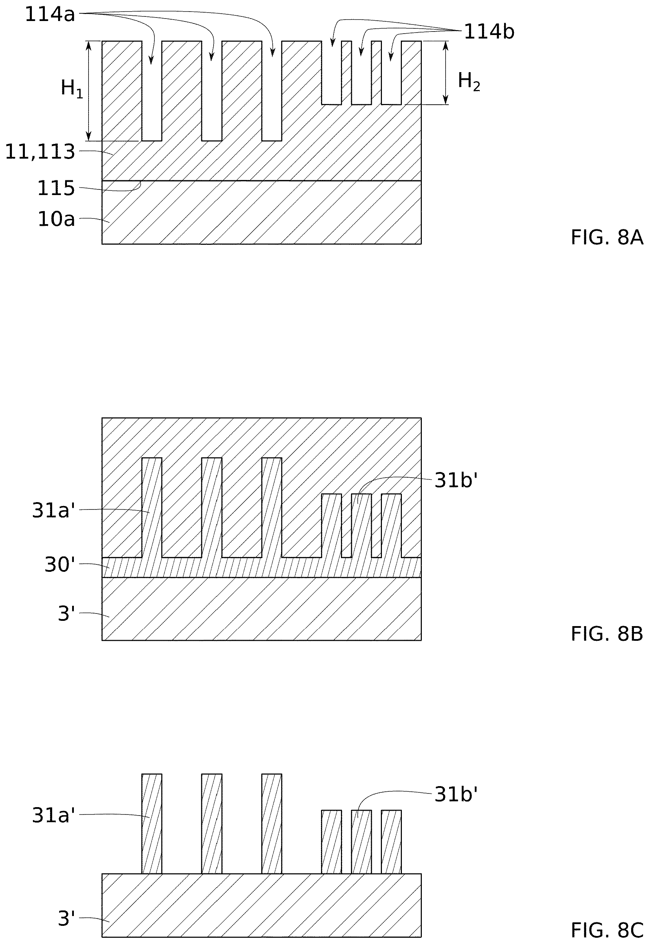

Le procédé de fabrication peut également être mis en oeuvre dans l'optique de fabriquer un moule dit direct, c'est-à-dire destiné à une réplication directe des motifs, sans passer par un moule maître puis une moule secondaire. Dans ce cas de figure, les dimensions des ouvertures 130a dans le masque de gravure et les paramètres d'implantation notamment seront cette fois choisis tels que le volume total Vb des zones en creux définies par le deuxième ensemble de motifs 114b est inférieur au volume total des zones en creux Va définies par le premier ensemble de motifs 114a. Pour cela on peut avoir, selon une variante ne faisant pas partie de l'invention, D2<D1 avec comme condition sur la hauteur des motifs H2<H1. On peut également avoir, selon une variante ne faisant pas partie de l'invention, D2<D1 et H2>H1 tant que Vb<Va. On peut également prévoir que D2>D1 selon l'invention, et H2<H1 tant que Vb<Va. Les dimensions D1, D2, H1 et H2 étant prises sur l'unique moule « direct », comme illustré en figure 8A. De cette façon, on obtient là encore une meilleure répartition de la résine et donc une couche résiduelle 30' d'épaisseur homogène lors de la nano-impression (figure 8B). Comme précédemment, les dimensions critiques des motifs 31a', 31b' sont préservées ou, tout du moins, moins dégradées que lors de procédés de l'état de la technique (figure 8C).

Exemple particulier de mise en œuvre du procédé par un utilisateur

Nous décrivons ci-dessous un exemple de mise en œuvre du procédé par un utilisateur, à titre non-limitatif.

- l'utilisateur choisit le matériau à implanter,
- en fonction du matériau choisi, l'utilisateur sélectionne des ions à implanter, qui :

  o modifient le matériau à implanter précédemment choisi, et
  o permettent d'identifier une chimie de gravure (sèche ou humide) pour graver sélectivement la/les portions implantées du matériau non implanté. Des essais expérimentaux sur pleines plaques (plaques sans ou avec motif) pourront être mis en œuvre pour identifier le ou les procédés de gravure optimal (optimaux),

- les conditions d'implantation sont alors déterminées par simulation en fonction des géométries voulues (par exemple profondeur des motifs),
- connaissant les ions et les conditions d'implantations on peut alors identifier des matériaux qui serviront de masque et de protection aux implantations, notamment des matériaux avec un pouvoir d'arrêt suffisant,
- le dépôt du masque et l'implantation ionique sont ensuite réalisés,
- le masque peut être retiré ou conservé pour un retrait ultérieur,
- la gravure sélective est mise en œuvre pour former les motifs,

- si les dimensions des motifs diffèrent des dimensions visées alors une correction sur les motifs peut être réalisée pour ajuster ces dimensions, par exemple par correction optique de proximité (communément abrégée OPC, de l'anglais *optical proximity correction).*

Au vu de la description qui précède, il apparaît clairement que l'invention propose un procédé de fabrication permettant d'améliorer la fabrication d'un moule pour la nano-impression pour contrôler l'épaisseur résiduelle de résine, ainsi qu'un moule améliorant le contrôle de l'épaisseur résiduelle de résine.

## Revendications

1.  Procédé de fabrication d'un moule (1) pour nano-impression comprenant :

    • une fourniture d'un substrat (10) comprenant une couche (11) présentant une face supérieure (110) et une face inférieure (115) opposée à la face supérieure (110),
    • au moins une implantation ionique dans au moins une portion de la couche (11), l'implantation ionique étant configurée de façon à obtenir au sein de la couche (11) au moins une première portion (111) non implantée ou présentant une première implantation, et au moins une deuxième portion (112) présentant une deuxième implantation, la première implantation et la deuxième implantation étant différentes, les première (111) et deuxième (112) portions s'étendant chacune depuis ladite face supérieure (110), l'implantation ionique définissant en outre une troisième portion (113) non implantée, s'étendant au moins depuis la première portion (111), jusqu'à la face inférieure (115) de la couche (10),
    • après ou avant l'implantation, la réalisation d'un masque, dit de gravure (13), surmontant la face supérieure (110) et présentant une pluralité d'ouvertures (130a, 130b),
    • après l'implantation, une gravure de la couche (10) configurée de façon à présenter une vitesse de gravure différente au moins entre la deuxième portion (112) et la troisième portion (113), de façon à graver à travers les ouvertures (130a, 130b) du masque de gravure (13) une pluralité de motifs (114a, 114b) de différentes hauteurs dans la couche, au moins un motif (114a) s'étendant dans la première portion (111) et au moins un motif (114b) s'étendant dans la deuxième portion (112), la gravure étant configurée pour graver dans la première portion (111) un premier ensemble de motifs (114a) et pour graver dans la deuxième portion (112) un deuxième ensemble de motifs (114b) :

        i. le premier ensemble de motifs (114a) présentant une première densité D1 de motifs et une première hauteur H1,
        ii. le deuxième ensemble de motifs (114b) présentant une deuxième densité D2 de motifs, et une deuxième hauteur H2, et dans lequel D2>D1,

    de préférence la première implantation et la deuxième implantation diffèrent par au moins un paramètre parmi : une profondeur d'implantation, une nature des ions implantés, une dose en ions implantées.

2.  Procédé selon la revendication précédente dans lequel la gravure est configurée de sorte que la vitesse de gravure au moins de la deuxième portion (112), est supérieure à la vitesse de gravure de la troisième portion non-implantée (113).

3.  Procédé selon l'une quelconque des revendications précédentes dans lequel, préalablement à l'implantation ionique, le procédé comprend la réalisation d'un masque (12) dit d'implantation sur au moins une portion (110a) de la face supérieure (110) de la couche (11), et l'implantation ionique est au moins en partie réalisée à travers le masque d'implantation (12) de sorte que la première portion implantée (111) présente une première profondeur d'implantation $P_1$ et la deuxième portion implantée (112) présente une deuxième profondeur d'implantation $P_2$, avec $P_2$ strictement supérieure à $P_1$ et $P_1$ nulle ou supérieure à 0, de préférence le masque d'implantation (12) est configuré de sorte à présenter un gradient d'épaisseur entre au moins une première épaisseur $E_1$ et une deuxième épaisseur $E_2$, avec $E_1$ strictement supérieure à $E_2$ et $E_2$ nulle ou supérieure à 0.

4.  Procédé selon la revendication précédente, dans lequel l'implantation ionique est configurée de sorte qu'au moins la deuxième profondeur d'implantation $P_2$ est supérieure à 30 nm.

5.  Procédé selon la revendication 3, dans lequel l'implantation ionique est configurée de sorte que les première $P_1$ et deuxième $P_2$ profondeurs d'implantation sont inférieures ou égale à 30 nm, de préférence inférieure ou égale à 10 nm.

6.  Procédé selon l'une quelconque des trois revendications précédentes, dans lequel le masque d'implantation (12) est configuré de sorte que les première (111) et deuxième (112) portions sont espacées, selon une direction parallèle à un plan d'extension principale de la face supérieure (110) de la couche (11), d'une distance ($L_0$) inférieure à la plus

petite distance ($L_1$) séparant deux motifs (114a, 114b) adjacents de différentes hauteurs.

7. Procédé selon l'une quelconque des quatre revendications précédentes, dans lequel le masque d'implantation (12) est configuré de sorte que les première (111) et deuxième (112) portions sont séparées par une portion intermédiaire (116) dans laquelle la profondeur d'implantation varie, ou le masque d'implantation (12) est configuré de sorte que les première (111) et deuxième (112) portions sont directement adjacentes.

8. Procédé selon l'une quelconque des revendications 1 et 2, dans lequel, préalablement à la gravure, le procédé comprend plusieurs implantations ioniques de façon à implanter une pluralité de premières portions (111) et une pluralité de deuxièmes portions (112), les implantations ioniques étant configurées entre elles de sorte que :

   • les premières portions (111) diffèrent des deuxième portions (112) par au moins un paramètre pris parmi : une nature des ions implantés, une dose en ions implantés, et/ou
   • les première et deuxième portions (111, 112) présentent des profondeurs d'implantation $P_1$, $P_2$ différentes entre les premières portions (111) et les deuxièmes portions (112)

   de préférence les implantations ioniques sont effectuées à travers le masque de gravure (13) de sorte que chacune des premières et deuxièmes portions implantées (111, 112) s'étend au droit des ouvertures (130a, 130b) du masque de gravure (13).

9. Procédé selon l'une quelconque des revendications 1 à 4 et 6 à 8, dans lequel la gravure est configurée pour graver sélectivement chaque portion implantée (111, 112) par rapport à la troisième portion non implantée (113).

10. Procédé selon l'une quelconque des revendications 1 à 4 et 6 à 9, dans lequel la gravure est stoppée après avoir consommée toute l'épaisseur de la deuxième portion (112) située au droit des ouvertures (130b) du masque de gravure (13).

11. Procédé selon l'une quelconque des revendications précédentes, dans lequel l'implantation ionique est configurée pour implanter au moins l'un parmi les ions oxygène, hydrogène, hélium, arsenic, phosphore et carbone, dans la couche (11).

12. Procédé selon l'une quelconque des revendications précédentes, dans lequel la couche (11) est à base d'au moins un parmi le silicium ou un matériau transparent à la longueur d'onde de 365 nm.

13. Procédé selon l'une quelconque des revendications précédentes, dans lequel H2>H1 ou H2<H1.

14. Moule (1) pour nano-impression comprenant :

   • un substrat (10) comprenant une couche (11) présentant une face supérieure (110) et une face inférieure (115) opposée à la face supérieure (110) et plusieurs motifs (114a, 114b) s'étendant depuis la face supérieure (110), la couche (11) étant destinée à pénétrer dans une couche à imprimer pour y transférer les motifs (114a, 114b), au moins l'un des motifs (114a) présentant une hauteur différente d'un autre motif (114b),

   **caractérisé en ce que** la couche (11) comprend au moins une première portion (111) non implantée ou présentant une première implantation, et au moins une deuxième portion (112) présentant une deuxième implantation, la première implantation et la deuxième implantation **étant différentes,** les première (111) et deuxième (112) portions s'étendant chacune depuis ladite face supérieure (110), et une troisième portion (113) non implantée, s'étendant au moins depuis la première portion (111), jusqu'à la face inférieure (115) de la couche (10), un premier ensemble de motifs (114a) s'étendant dans la première portion (111) et un deuxième ensemble de motifs (114b) s'étendant dans la deuxième portion (112), avec :

   i. le premier ensemble de motifs (114a) présentant une première densité D1 de motifs et une première hauteur H1,
   ii. le deuxième ensemble de motifs (114b) présentant une deuxième densité D2 de motifs, et une deuxième hauteur H2, et dans lequel D2>D1,

   de préférence, le moule est un moule dit maître, destiné à servir à la réalisation de moules secondaires pour nano-impression, et H2>H1, ou, le moule est un moule dit direct, destiné à servir à la nano-impression, et H2<H1.

15. Moule (1) selon la revendication précédente, dans lequel la première portion implantée (111) présente une première profondeur d'implantation $P_1$ et la deuxième portion implantée (112) présente une deuxième profondeur d'implantation $P_2$, avec $P_2$ strictement supérieure à $P_1$ et $P_1$ nulle ou supérieure à 0, de préférence les première (111) et deuxième (112) portions sont espacées, selon une direction parallèle au plan d'extension principale de la face supérieure (110) de la couche (11), d'une distance ($L_0$) inférieure à la plus petite distance ($L_1$) séparant deux motifs (114a, 114b) adjacents de différentes hauteurs.

**Patentansprüche**

1. Verfahren zur Herstellung einer Nanoimprintform (1), das Folgendes umfasst:

   • eine Bereitstellung eines Substrats (10), das eine Schicht (11) umfasst, die eine obere Fläche (110) und eine untere Fläche (115), der oberen Fläche (110 entgegengesetzt liegend, aufweist,
   • mindestens eine Ionenimplantation in mindestens einem Abschnitt der Schicht (11), wobei die Ionenimplantation derart konfiguriert ist, dass innerhalb der Schicht (11) mindestens ein erster nicht implantierter Abschnitt (111) oder der eine erste Implantation aufweist, erhalten wird, und mindestens ein zweiter Abschnitt (112), der eine zweite Implantation aufweist, wobei sich die erste Implantation und die zweite Implantation unterscheiden, sich der erste (111) und der zweite Abschnitt (112) jeweils von der oberen Fläche (110) erstrecken, die Ionenimplantation außerdem einen nicht implantierten dritten Abschnitt (113) definiert, der sich mindestens von dem ersten Abschnitt (111) bis zu der unteren Fläche (115 der Schicht (10) erstreckt,
   • nach oder vor der Implantation die Herstellung einer Maske, als Ätzmaske (13) bezeichnet, die die obere Fläche (110) überlagert und eine Vielzahl von Öffnungen (130a, 130b) aufweist,
   • nach der Implantation eine Ätzung der Schicht (10), die derart konfiguriert ist, dass sie eine Ätzgeschwindigkeit aufweist, die sich mindestens zwischen dem zweiten Abschnitt (112) und dem dritten Abschnitt (113) derart unterscheidet, dass durch die Öffnungen (130a, 130b) der Ätzmaske (13) eine Vielzahl von Strukturen (114a, 114b) mit unterschiedlichen Höhen in der Schicht geätzt wird, wobei sich mindestens eine Struktur (114a) in dem ersten Abschnitt (111) erstreckt, und sich mindestens eine Struktur (114b) in dem zweiten Abschnitt (112) erstreckt, wobei die Ätzung dazu konfiguriert ist, in dem ersten Abschnitt (111) eine erste Anordnung von Strukturen (114a) zu ätzen und in dem zweiten Abschnitt (112) eine zweite Anordnung von Strukturen (114b) zu ätzen:

     i. wobei die erste Anordnung von Strukturen (114a) eine erste Dichte D1 von Strukturen und eine erste Höhe H1 aufweist,
     ii. die zweite Anordnung von Strukturen (114b) eine zweite Dichte D2 von Strukturen und eine zweite Höhe H2 aufweist, und wobei D2>D1, wobei sich bevorzugt die erste Implantation und die zweite Implantation durch mindestens einen Parameter unterscheiden unter:
     einer Implantationstiefe, einer Beschaffenheit der implantierten Ionen, einer Dosis implantierter Ionen.

2. Verfahren nach dem vorstehenden Anspruch, wobei die Ätzung derart konfiguriert ist, dass die Ätzgeschwindigkeit mindestens des zweiten Abschnitts (112) größer als die Ätzgeschwindigkeit des dritten nicht implantierten Abschnitts (113) ist.

3. Verfahren nach einem der vorstehenden Ansprüche, wobei das Verfahren vor der Ionenimplantation die Herstellung einer als Implantationsmaske bezeichneten Maske (12), auf mindestens einem Abschnitt (110a) der oberen Fläche (110) der Schicht (11) umfasst, und die Ionenimplantation mindestens zum Teil durch die Implantationsmaske (12) derart durchgeführt wird, dass der erste implantierte Abschnitt (111) eine erste Implantationstiefe $P_1$ aufweist, und der zweite implantierte Abschnitt (112) eine zweite Implantationstiefe $P_2$ aufweist, wobei $P_2$ strikt größer ist als $P_1$ und $P_1$ gleich null oder größer als 0 ist, die Implantationsmaske (12) bevorzugt derart konfiguriert ist, dass sie einen Dickengradienten zwischen mindestens einer ersten Dicke $E_1$ und einer zweiten Dicke E2 aufweist, wobei $E_1$ strikt größer als $E_2$ ist und $E_2$ gleich 0 oder größer als 0 ist.

4. Verfahren nach dem vorstehenden Anspruch, wobei die Ionenimplantation derart konfiguriert ist, dass mindestens die zweite Implantationstiefe $P_2$ größer als 30 nm ist.

5. Verfahren nach Anspruch 3, wobei die Ionenimplantation derart konfiguriert ist, dass die erste $P_1$ und die zweite $P_2$ Implantationstiefe kleiner oder gleich 30 nm, bevorzugt kleiner oder gleich 10 nm sind.

6. Verfahren nach einem der drei vorstehenden Ansprüche, wobei die Implantationsmaske (12) derart konfiguriert ist, dass der erste (111) und der zweite Abschnitt (112) entlang einer Richtung parallel zu einer Hauptausdehnungsebene der oberen Fläche (110) der Schicht (11) um einen Abstand ($L_0$) kleiner als der kleinere Abstand ($L_1$), der zwei angrenzende Strukturen (114a, 114b) mit unterschiedlichen Höhen trennt, beabstandet sind.

7. Verfahren nach einem der vier vorstehenden Ansprüche, wobei die Implantationsmaske (12) derart konfiguriert ist, dass der erste (111) und der zweite Abschnitt (112) durch einen Zwischenabschnitt (116) getrennt sind, in dem die Implantationstiefe variiert, oder die Implantationsmaske (12) derart konfiguriert ist, dass der erste (111) und der zweite Abschnitt (112) direkt angrenzend sind.

8. Verfahren nach einem der Ansprüche 1 und 2, wobei vor der Ätzung das Verfahren mehrere Ionenimplantationen derart umfasst, dass eine Vielzahl erster Abschnitte (111) und eine Vielzahl zweiter Abschnitte (112) implantiert werden, wobei die Ionenimplantationen zueinander derart konfiguriert sind, dass:

- sich die ersten Abschnitte (111) von den zweiten Abschnitten (112) durch mindestens einen Parameter unterscheiden, der genommen wird aus: einer Beschaffenheit der implantierten Ionen, einer Dosis implantierter Ionen, und/oder
- der erste und der zweite Abschnitt (111, 112) Implantationtiefen $P_1$, $P_2$ aufweisen, die sich von den ersten Abschnitten (111) und den zweiten Abschnitten (112) unterscheiden,
- die Ionenimplantationen bevorzugt durch die Ätzmaske (13) hindurch derart erfolgen, dass sich jeder der ersten und zweiten implantierten Abschnitte (111, 112) senkrecht zu den Öffnungen (130a, 130b) der Ätzmaske (13) erstreckt.

9. Verfahren nach einem der Ansprüche 1 bis 4 und 6 bis 8, wobei die Ätzung dazu konfiguriert ist, selektiv jeden implantierten Abschnitt (111, 112) in Bezug auf den dritten nicht implantierten Abschnitt (113) zu ätzen.

10. Verfahren nach einem der Ansprüche 1 bis 4 und 6 bis 9, wobei die Ätzung gestoppt wird, nachdem die gesamte Dicke des zweiten Abschnitts (112), der im rechten Winkel zu den Öffnungen (130b) der Ätzmaske (13) liegt, verbraucht ist.

11. Verfahren nach einem der vorstehenden Ansprüche, wobei die Ionenimplantation dazu konfiguriert ist, mindestens eines aus Sauerstoff-, Wasserstoff-, Helium-, Arsen-, Phosphor- und Kohlenstoffionen in der Schicht (11) zu implantieren.

12. Verfahren nach einem der vorstehenden Ansprüche, wobei die Schicht (11) auf mindestens einem aus Silizium oder einem bei der Wellenlänge von 365 nm transparenten Material basiert.

13. Verfahren nach einem der vorstehenden Ansprüche, wobei H2>H1 oder H2<H1.

14. Nanoimprintform (1), die Folgendes umfasst:

- ein Substrat (10), das eine Schicht (11) umfasst, die eine obere Fläche (110) und eine untere Fläche (115), die der oberen Fläche (110) entgegengesetzt liegt, und mehrere Strukturen (114a, 114b), die sich von der oberen Fläche (110) erstrecken, umfasst, wobei die Schicht (11) dazu bestimmt ist, in eine zu bedruckende Schicht einzudringen, um dorthin die Strukturen (114a, 114b) zu transferieren, wobei mindestens eine der Strukturen (114a) eine Höhe aufweist, die sich von einer anderen Struktur (114b) unterscheidet,

**dadurch gekennzeichnet, dass** die Schicht (11) mindestens einen ersten nicht implantierten Abschnitt (111) umfasst oder eine erste Implantation aufweist, und mindestens einen zweiten Abschnitt (112), der eine zweite Implantation aufweist, wobei sich die erste Implantation und die zweite Implantation voneinander unterscheiden, wobei sich der erste (111) und der zweite Abschnitt (112) jeweils von der oberen Fläche (110) erstrecken, und einen dritten nicht implantierten Abschnitt (113), der sich mindestens von dem ersten Abschnitt (111) bis zu der unteren Fläche (115) der Schicht (10) erstreckt, wobei sich erste Anordnung von Strukturen (114a) in dem ersten Abschnitt (111) erstreckt, und sich eine zweite Anordnung von Strukturen (114b) in dem zweiten Abschnitt (112) erstreckt, wobei:

i. die erste Anordnung von Strukturen (114a) eine erste Dichte D1 von Strukturen und eine erste Höhe H1 aufweist,
ii. die zweite Anordnung von Strukturen (114b) eine zweite Dichte D2 von Strukturen und eine zweite Höhe H2 aufweist,

und wobei D2>D1,
die Form bevorzugt eine so genannte Masterform ist, die dazu bestimmt ist, zur Herstellung von Nanoimprint-Sekundärformen zu dienen, und H2>H1, oder die Form eine so genannte direkte Form ist, die dazu bestimmt ist, für Nanoimprint zu dienen, und H2<H1.

15. Form (1) nach dem vorstehenden Anspruch, wobei der erste implantierte Abschnitt (111) eine erste Implantationstiefe $P_1$ aufweist, und der zweite implantierte Abschnitt (112) eine zweite Implantationstiefe $P_2$ aufweist, wobei $P_2$ strikt größer ist als $P_1$ und $P_1$ gleich 0 oder größer als 0 ist, der erste (111) und der zweite Abschnitt (112) bevorzugt entlang einer Richtung parallel zu der Hauptausdehnungsebene der oberen Fläche (110) der Schicht (11) um einen Abstand ($L_0$) kleiner als der kleinste Abstand ($L_1$), der zwei angrenzenden Strukturen (114a, 114b) mit unterschiedlichen Höhen trennt, beabstandet sind.

**Claims**

1. Method for manufacturing a mould (1) for nanoprinting, comprising:

- a provision of a substrate (10) comprising a layer (11) having an upper face (110) and a lower face (115) opposite the upper face (110),
- at least one ion implantation in at least one portion of the layer (11), the ion implantation being configured, so as to obtain within the layer (11) at least one first non-implanted portion (111) or having a first implantation, and at least one second portion (112) having a second implantation, the first implantation and the second implantation being different, the first (111) and second (112) portions each extending from said upper face (110), the ion implantation further defining a third non-implanted portion (113), extending at least from the first portion (111), to the lower face (115) of the layer (10),
• after or before implantation, the production of a so-called etching mask (13), surmounting the upper face (110) and having a plurality of openings (130a, 130b),
• after implantation, an etching of the layer (10) configured so as to have a different etching speed at least between the second portion (112) and the third portion (113), so as to etch through the openings (130a, 130b) of the etching mask (13), a plurality of patterns (114a, 114b) of different heights in the layer, at least one pattern (114a) extending into the first portion (111) and at least one pattern (114b) extending into the second portion (112), the etching being configured to etch in the first portion (111), a first set of patterns (114a) and to etch in the second portion (112), a second set of patterns (114b):

   i. the first set of patterns (114a) having a first pattern density D1 and a first height H1,
   ii. the second set of patterns (114b) having a second pattern density D2, and a second height H2, and wherein D2>D1,

preferably the first implantation and the second implantation differ by at least one parameter from among: an implantation depth, a nature of the implanted ions, a dose of implanted ions.

2. Method according to any one of the preceding claims, wherein the etching is configured such that the etching speed at least of the second portion (112), is greater than the etching speed of the third non-implanted portion (113).

3. Method according to any one of the preceding claims, wherein, prior to the ion implantation, the method comprises the production of a so-called implantation mask (12) on at least one portion (110a) of the upper face (110) of the layer (11), and the ion implantation is at least partially performed through the implantation mask (12), such that the first implanted portion (111) has a first implantation depth $P_1$ and the second implanted portion (112) has a second implantation depth $P_2$, with $P_2$ strictly greater than $P_1$ and $P_1$ zero or greater than 0, preferably the implantation mask (12) is configured so as to have a thickness gradient between at least one first thickness $E_1$ and one second thickness $E_2$, with $E_1$ strictly greater than $E_2$ and $E_2$ zero or greater than 0.

4. Method according to the preceding claim, wherein the ion implantation is configured, such that at least the second implantation depth $P_2$ is greater than 30nm.

5. Method according to claim 3, wherein the ion implantation is configured, such that the first $P_1$ and second $P_2$ implantation depths are less than or equal to 30nm, preferably less than or equal to 10nm.

6. Method according to any one of the three preceding claims, wherein the implantation mask (12) is configured such that the first (111) and second (112) portions are spaced apart, in a direction parallel to a main extension plane of the upper face (110) of the layer (11), by a distance ($L_0$) less than the smallest distance ($L_1$) separating two adjacent patterns (114a, 114b) of different heights.

7. Method according to any one of the four preceding claims, wherein the implantation mask (12) is configured, such that the first (111) and second (112) portions are separated by an intermediate portion (116), wherein the implantation depth varies, or the implantation mask (12) is configured, such that the first (111) and second (112) portions are directly adjacent.

8. Method according to any one of claims 1 and 2, wherein, prior to the etching, the method comprises several ion implantations, so as to implant a plurality of first portions (111) and a plurality of second portions (112), the ion implantations being configured together, such that:

   • the first portions (111) differ from the second portions (112) by at least one parameter taken from among: a nature of the implanted ions, a dose of implanted ions, and/or
   • the first and second portions (111, 112) have different implantation depths $P_1$, $P_2$ between the first portions (111) and the second portions (112),

preferably the ion implantations are performed through the etching mask (13), such that each of the first and second implanted portions (111, 112) extends in line with the openings (130a, 130b) of the etching mask (13).

9. Method according to any one of claims 1 to 4 and 6 to 8, wherein the etching is configured to selectively etch each implanted portion (111, 112) with respect to the third non-implanted portion (113).

**10.** Method according to any one of claims 1 to 4 and 6 to 9, wherein the etching is stopped after having consumed the entire thickness of the second portion (112) located in line with the openings (130b) of the etching mask (13).

**11.** Method according to any one of the preceding claims, wherein the ion implantation is configured to implant at least one from among oxygen, hydrogen, helium, arsenic, phosphor and carbon ions, in the layer (11).

**12.** Method according to any one of the preceding claims, wherein the layer (11) is with the basis of at least one from among silicon or a transparent material with a 365nm wavelength.

**13.** Method according to any one of the preceding claims, wherein H2>H1 or H2<H1.

**14.** Mould (1) for nanoprinting, comprising:

• a substrate (10) comprising a layer (11) having an upper face (110) and a lower face (115) opposite the upper face (110) and several patterns (114a, 114b) extending from the upper face (110), the layer (11) being intended to penetrate into a layer to be printed to transfer the patterns (114a, 114b) there, at least one of the patterns (114a) having a height different from another pattern (114b),

**characterised in that** the layer (11) comprises at least one first non-implanted portion (111) or portion having a first implantation, and at least one second portion (112) having a second implantation, the first implantation and the second implantation being different, the first (111) and second (112) portions each extending from said upper face (110), and a third non-implanted portion (113), extending at least from the first portion (111), to the lower face (115) of the layer (10), a first set of patterns (114a) extending into the first portion (111) and a second set of patterns (114b) extending into the second portion (112), with:

i. the first set of patterns (114a) having a first pattern density D1 and a first height H1,
ii. the second set of patterns (114b) having a second pattern density D2, and a second height H2, and wherein D2>D1,

preferably the mould is a so-called master mould, intended to serve for the production of secondary moulds for nanoprinting, and H2>H1, or, the mould is a so-called direct mould, intended to serve the nanoprinting, and H2<H1.

**15.** Mould (1) according to the preceding claim, wherein the first implanted portion (111) has a first implantation depth $P_1$ and the second implanted portion (112) has a second implantation depth $P_2$, with $P_2$ strictly greater than $P_1$ and $P_1$ zero or greater than 0, preferably the first (111) and second (112) portions are spaced apart, in a direction parallel to the main extension plane of the upper face (110) of the layer (11), by a distance ($L_0$) less than the smallest distance ($L_1$) separating two adjacent patterns (114a, 114b) of different heights.

31a

31b

30

30

3

FIG. 1A

31a

31b

30

3

FIG. 1B

31a

31b

3

FIG. 1C

FIG. 2A

FIG. 2B

FIG. 3A

FIG. 3B

FIG. 3C

FIG. 4A

FIG. 4B

FIG. 4C

FIG. 5A

FIG. 5B

FIG. 5C

FIG. 6A

FIG. 6B

FIG. 6C

FIG. 6D

200

114a

$H_1$

11,113

115

10a

114b $H_2$

FIG. 6E

200

31a'

30'

3'

31b'

FIG. 6F

31b'

31a'

3'

FIG. 6G

FIG. 7A

FIG. 7B

114a

H₁ → $H_1$

114b

$H_2$

11,113

115

10a

FIG. 8A

31a'

31b'

30'

3'

FIG. 8B

31a'

31b'

3'

FIG. 8C

**EP 4 406 006 B1**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2019369310 A1

- US 2016308020 A1